# EUROPEAN PATENT APPLICATION

(11) **EP 4 518 597 A1**
(43) Date of publication of application: **05.03.2025**
(21) Application number: 24197621.6
(22) Date of filing: 30.08.2024
(51) Int. Cl.: H05K 7/14, H02M 7/00, H05K 7/20

(54) **POWER ASSEMBLY APPARATUS AND LIQUID COOLING CONVERTER THEREOF**

(30) Priority: 31.08.2023 CN 202311115649; 31.08.2023 CN 202311115675; 31.08.2023 CN 202311115678; 31.08.2023 CN 202311115681; 31.08.2023 CN 202311115688
(71) Applicant: Xiamen Kehua Digital Energy Tech Co., Ltd., Xiamen, Fujian 361101 (CN)
(72) Inventor: WEI, Ligui, Xiamen, 361101 (CN); ZHAO, Xiaohang, Xiamen, 361101 (CN); NI, Zelian, Xiamen, 361101 (CN); LIN, Zhenhuang, Xiamen, 361101 (CN); HONG, Peizai, Xiamen, 361101 (CN); XU, Linyi, Xiamen, 361101 (CN)
(74) Representative: Regimbeau

(57) **Abstract**

A power assembly apparatus includes a capacitor module, a power module and at least one heat sink. The capacitor includes interconnected direct current (DC) capacitor banks and a capacitor bus. The capacitor bus has a connection part. The power module has an input bus, an output bus, and three single-phase switching tube groups. Each single-phase switching tube group includes a plurality of switching modules. Each switching module is coupled to input tubes and output tubes. The input bus is connected to the connection part. The output bus is configured to output electrical energy. The heat sink has a mounting surface for mounting each of the single-phase switching tube groups for efficiently move away heat generated by the single-phase switching tube groups.

## Description

### FIELD

The present invention is related to a power assembly apparatus, and more particularly related to a power assembly apparatus with nice heat dissipation capability.

### BACKGROUND

The demand for high-voltage and high-current conversion has grown substantially across multiple industries. Power conversion systems are fundamental in sectors such as renewable energy, automotive, and telecommunications. These systems must handle increasingly larger voltage and current levels to meet the energy needs of modern applications. The development of robust and reliable power conversion technologies is crucial to support the growing power demands while ensuring safety and efficiency.

The importance of heat dissipation, high-voltage, and high-current power conversion cannot be overstated in modern technology. These factors are critical in various applications, including Al, renewable energy, automotive, and telecommunications. Ensuring the stability and reliability of power systems through advanced thermal management and robust design practices is essential to meet the growing demands of these industries. As technology continues to evolve, the development of innovative solutions for power management and heat dissipation will remain a key focus for engineers and designers.

### SUMMARY

In some embodiments, a power assembly apparatus includes a capacitor module, a power module and at least one heat sink.

The invention is defined in the claims.

### BRIEF DESCRIPTION OF DRAWINGS

Fig. 1 illustrates a power assembly apparatus embodiment.
Fig. 2 illustrates a side view of the example in Fig. 1.
Fig. 3a illustrates a circuit diagram of the embodiment in Fig. 1.
Fig. 3b illustrates three single-phase switching tube groups arrangement.
Fig. 4a illustrates an arrangement of single-phase switching tube groups.
Fig. 4b illustrates a side view of arrangement of components.
Fig. 5a illustrates another arrangement of components.
Fig. 5b illustrates a side view of the arrangement in Fig. 5a.
Fig. 6a illustrates another arrangement.
Fig. 6b illustrates a side view of the arrangement in Fig. 6a.
Fig. 7a illustrates another arrangement.
Fig. 7b illustrates a side view of the arrangement in Fig. 7a.
Fig. 8a illustrates an arrangement of components.
Fig. 8b illustrates another view of the example in Fig. 8a.
Fig. 9a illustrates another embodiment for different arrangement.
Fig. 9b illustrates another view of the example in Fig. 9a.
Fig. 10a illustrates another embodiment for a different arrangement.
Fig. 10b illustrates a different view of the example of Fig. 10a.
Fig. 11a illustrates another embodiment of a different arrangement.
Fig. 11b illustrates another view of the example in Fig. 11a.
Fig. 12a illustrates anther embodiment of another arrangement.
Fig. 12b illustrates anther view of the example in Fig. 12a.
Fig. 13a illustrates another embodiment of a different arrangement.
Fig. 13b illustrates another view of the example in Fig. 13a.
Fig. 14 illustrates a perspective view of an embodiment.
Fig. 15 illustrates a side view of an example.
Fig. 16 illustrates different views of the example.
Fig. 17 illustrates a cross-sectional view of an example.
Fig. 18a illustrates two arrangements of components.
Fig. 18b illustrates a side view of the example in Fig. 18a.
Fig. 19 illustrates another view of an example.
Fig. 20 illustrates an example showing how to perform heat dissipation with intelligence control.

### DETAILED DESCRIPTION

Converters are widely used in power systems, rail transit, military industry, petroleum machinery, new energy vehicles, wind power generation, solar photovoltaics, and other fields. They connect between battery systems and power grids to achieve bidirectional conversion of electrical energy. Converters can control the charging and discharging processes of storage batteries, perform AC-DC conversions, and supply power directly to AC loads in the absence of a power grid. Additionally, NPC (Neutral Point Clamp) or ANPC (Active Neutral Point Clamp) three-level topologies can use low blocking voltage IGBT devices to increase DC bus voltage, thereby improving AC output voltage and expanding system power levels. Therefore, these topologies are widely used in converters.

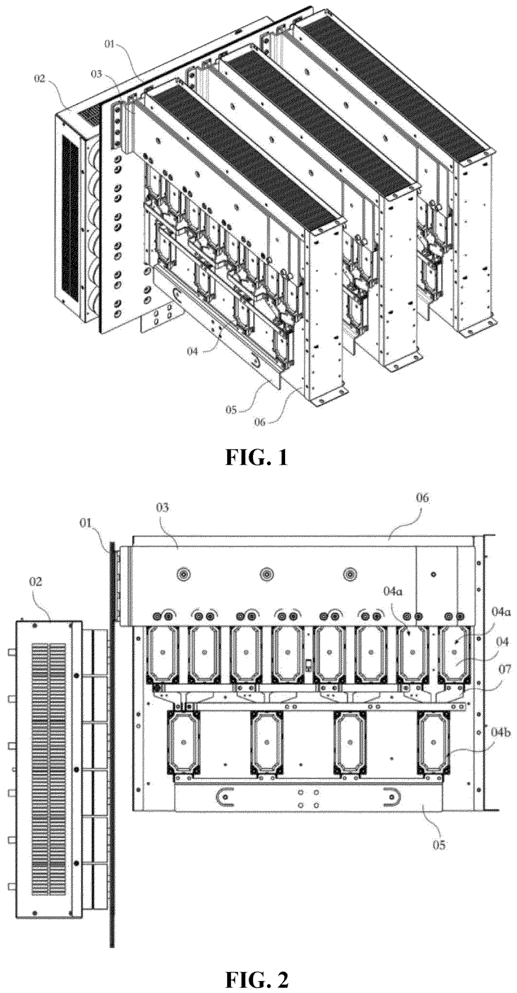

As shown in Fig. 1, it illustrates the structure of a power assembly in a conventional converter with a three-level topology. The power assembly mainly includes a capacitor bus 01, DC capacitor banks 02, input bus 03, switching tubes 04, output bus 05, heat sink 06, and connecting strips 07.

The capacitor bus 01 and DC capacitor banks 02 cooperate to form a capacitor module. The capacitor bus 01 includes a positive plate, a middle plate, and a negative plate. According to the three-level topology circuit structure, each capacitor device in the DC capacitor banks 02 is connected to different polarity plates on the capacitor bus 01.

Since the output of this power assembly is three-phase AC, it includes three groups of single-phase switching tube groups. Each group of single-phase switching tube groups includes multiple switching modules, a heat sink 06, a set of input buses 03, a set of connecting strips 07, and an output bus 05. The heat sink 06 is an air-cooled heat sink with an installation surface on one side for mounting the switching tubes 04, while the other side, which faces away from the installation surface, is arranged with heat dissipation fins.

Refer to Fig. 2 for further illustration. Each switching module includes three switching tubes 04. Among the three switching tubes 04, the upper ones are two input tubes 04a, and the lower one is an output tube 04b. The two input tubes 04a are connected via connecting strips 07 between them and to the output tube 04b below. The switching modules are connected in parallel. Parallel connections can improve the output current capability of the bridge arm in a single three-level topology structure. This power assembly adopts a structure with four switching modules connected in parallel. A set of input buses 03 corresponds to the capacitor bus 01, with the positive plate, middle plate, and negative plate respectively connected to the corresponding plates on the capacitor bus 01. The output bus 05 is connected to the output ends of the four switching modules to provide single-phase AC output. The output buses 05 of the three switching modules jointly provide three-phase AC output.

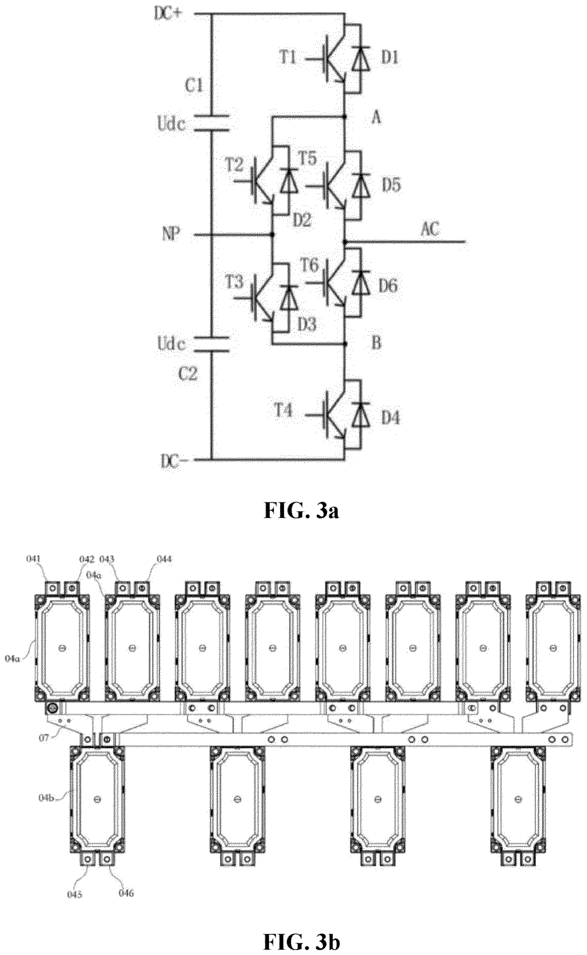

Refer to Figs. 3a and 3b for detailed explanation using a group of switching modules as an example. Fig. 3a shows the circuit schematic of the three-level topology structure, and Fig. 3b shows the actual connection schematic of the switching tubes 04. In a switching module, there are two input tubes 04a and one output tube 04b. The terminals of the two input tubes 04a connected to the input bus 03 include a positive terminal 041, a first middle terminal 042, a second middle terminal 043, and a negative terminal 044. The positive terminal 041 is connected to the positive plate of the input bus 03, the first middle terminal 042 and the second middle terminal 043 are connected to the middle plate of the input bus 03, and the negative terminal 044 is connected to the negative plate of the input bus 03. After connecting the lower end terminals of the two input tubes 04a, they are respectively connected to the output tube 04b below through connecting strips 07. The lower end of the output tube 04b has a first output terminal 045 and a second output terminal 046, both connected to the output bus 05. The input tubes 04a can include T1, D1, T2, D2 as shown in Fig. 3a; the output tubes can include T3, D3, T4, D4; and the output tubes can include T5, D5, T6, D6 as shown in Fig. 3a.

In a switching module, the corresponding terminals of the input tubes 04a form the input end of the switching module, and the corresponding terminals of the output tube 04b form the output end of the switching module. In a single-phase switching tube group, the input ends of the switching modules form the input end of the single-phase switching tube group, and the output ends of the switching modules form the output end of the single-phase switching tube group.

It is evident that this type of power assembly has the following problems: the power assembly is relatively large in size, making it unsuitable for small or specialized electrical cabinets. Additionally, the power assembly uses a large number of copper bus layers to reduce stray inductance generated during commutation, resulting in high manufacturing costs for the power assembly.

The objective of this invention is to overcome at least one defect or issue present in the background technology and to provide a power assembly apparatus and converter.

This invention and its related embodiments adopt, but are not limited to, the following technical solutions:

The first technical solution and its related embodiments involve a power assembly apparatus, which includes a capacitor module comprising interconnected direct current (DC) capacitor banks and a capacitor bus. The capacitor bus has a connection part. The power module includes an input bus, an output bus, and three single-phase switching tube groups. Each single-phase switching tube group includes multiple switching modules connected to the input bus and output bus. The input bus is connected to the connection part, and the output bus is used to output electrical energy. Each switching module includes switching tubes classified into input tubes and output tubes. It also includes at least one heat sink with two opposite mounting surfaces for installing each single-phase switching tube group. Each switching module is divided into parts that only include input tubes and parts that only include output tubes. Any mounting surface of the same heat sink includes only one part.

The second technical solution, based on the first, is a preferred embodiment wherein both mounting surfaces are parallel to the connection part. One mounting surface faces the connection part, and the other mounting surface faces away from the connection part.

The third technical solution, based on the second, is a preferred embodiment wherein, in each single-phase switching tube group, the input tubes and output tubes in each part are arranged in parallel along the left-right direction. The input tubes and output tubes in each switching module are connected via connecting strips.

The fourth technical solution, based on the third, is a preferred embodiment wherein the input tubes of each switching module are installed on the mounting surface facing the capacitor bus, and the output tubes are installed on the mounting surface facing away from the capacitor bus.

The fifth technical solution, based on the fourth, is a preferred embodiment wherein there is one heat sink. The three single-phase switching tube groups are arranged sequentially in the upper, middle, and lower parts of the heat sink. For the single-phase switching tube groups at the upper and/or lower parts of the heat sink, the connecting strips bypass the upper and/or lower edges of the heat sink. For the single-phase switching tube groups in the middle of the heat sink, the connecting strips pass through the heat sink from front to back.

The sixth technical solution, based on the fourth, is a preferred embodiment wherein there is one heat sink. The three single-phase switching tube groups are arranged sequentially in the upper, middle, and lower parts of the heat sink. For the single-phase switching tube groups at the upper, middle, and/or lower parts of the heat sink, the connecting strips pass through the heat sink from front to back.

The seventh technical solution, based on the fourth, is a preferred embodiment wherein the single-phase switching tube groups are arranged in parallel along the vertical direction on the heat sink. There are three heat sinks arranged vertically, each with one single-phase switching tube group. The connecting strips for each single-phase switching tube group bypass the upper or lower edges of the heat sink they are located on.

The eighth technical solution, based on the fourth, is a preferred embodiment wherein there is one heat sink. The three single-phase switching tube groups are arranged in parallel along the horizontal direction on the heat sink. The input ends of all three single-phase switching tube groups are connected to the same input bus. The connecting strips for each single-phase switching tube group bypass the upper or lower edges of the heat sink they are located on.

The ninth technical solution, based on the fourth, is a preferred embodiment wherein the single-phase switching tube groups are arranged in parallel along the horizontal direction on three heat sinks. Each heat sink has one single-phase switching tube group. The input ends of all three single-phase switching tube groups are connected to the same input bus. The connecting strips for each single-phase switching tube group bypass the upper or lower edges of the heat sink they are located on.

The tenth technical solution and its related embodiments involve a liquid-cooled converter that includes any of the power assembly apparatuses described in the first to ninth technical solutions. The heat sink used is a liquid-cooled heat sink.

From the above description of the invention and its specific embodiments, it is evident that compared to the existing technology, the technical solutions and related embodiments of this invention have the following beneficial effects due to the adoption of the following technical means:

The inventors have observed through continuous experiments and research that the cause of the technical issue of the "large volume of the power assembly" in existing technology is due to the use of air-cooled heat sinks. The heat sinks have only one surface available for mounting switching tubes, leading to low surface utilization and large layout areas for the switching tubes.

In response, the first technical solution and related embodiments use heat sinks with two mounting surfaces. Both mounting surfaces can be used to mount switching tubes and dissipate heat, improving surface utilization of the heat sinks and reducing the layout area of the switching tubes. Additionally, each single-phase switching tube group is divided into two parts based on the types of switching tubes included: one part includes input tubes, and the other part includes output tubes. These two parts are installed on the two mounting surfaces of the heat sink, ensuring that the input and output buses do not cross each other during wiring, facilitating the wiring of the switching modules and the installation of the input and output buses. This also makes maintenance easier.

In the second technical solution and related embodiments, both mounting surfaces are parallel to the connection part, allowing the heat sink to be arranged in a stacked manner with the capacitor bus, reducing the thickness of the power assembly and minimizing space occupation, making it more suitable for practical use.

In the third technical solution and related embodiments, in each single-phase switching tube group, the switching tubes in both parts are arranged in parallel along the left-right direction. This allows the input tubes to share the same input bus extending in the left-right direction, and the output tubes to share the same output bus, facilitating the wiring of the switching modules and the installation of the input and output buses. This also ensures that the distance from the input ends of each switching module to the connection part of the capacitor bus is consistent, improving the balance of the current loop and reducing stray inductance.

In the fourth technical solution and related embodiments, all input tubes of the switching modules are installed facing the capacitor bus, and all output tubes are installed facing away from the capacitor bus. This reduces the distance from the input tubes to the connection part of the capacitor bus, and the installation of the input and output buses will not cross or cover each other, making the overall wiring simpler and safer.

In the fifth and sixth technical solutions and related embodiments, the three single-phase switching tube groups are arranged sequentially along the vertical direction, reducing the width of the required heat sink. The shape of the heat sink is more rectangular, facilitating the installation of the heat sink and power module in the converter. Additionally, the connecting strips of the single-phase switching tube group located in the middle of the heat sink can pass through the heat sink to connect the input and output tubes on the two mounting surfaces, while the single-phase switching tube groups located at the edges of the heat sink can choose to have the connecting strips bypass the edges of the heat sink or pass through the heat sink, facilitating the connection of the input and output tubes in each switching module. Since the connecting strips of the single-phase switching tube group in the middle do not need to bypass the edges of the heat sink, the commutation loop of this single-phase switching tube group is smaller, reducing the overall stray inductance of the power assembly and facilitating the wiring of this single-phase switching tube group.

In the seventh technical solution and related embodiments, three heat sinks are set up, each with one single-phase switching tube group, reducing the heat dissipation pressure on the heat sinks, lowering the requirements for the heat sinks, and reducing the manufacturing cost of the heat sinks. Additionally, the connecting strips can bypass the edges of the heat sinks without the need for openings in the heat sinks, further reducing the manufacturing cost.

In the eighth technical solution and related embodiments, the three single-phase switching tube groups are arranged in parallel along the horizontal direction, reducing the height of the required heat sink, improving surface utilization, and reducing the overall volume of the heat sink. Additionally, one heat sink with three single-phase switching tube groups allows all single-phase switching tube groups to share the same input bus, reducing the preparation and installation costs of the input bus. The distance from each single-phase switching tube group to the connection part of the capacitor bus is consistent, improving the balance of the current loop.

In the ninth technical solution and related embodiments, three heat sinks are set up, each with one single-phase switching tube group, reducing the heat dissipation pressure on the heat sinks, lowering the requirements for the heat sinks, and reducing the manufacturing cost of the heat sinks.

In the tenth technical solution and related embodiments, a liquid-cooled converter is provided, using liquid-cooled heat sinks, which, based on the power assembly apparatus used, have the above-mentioned technical effects.

For the structure of the power module, the inventor found that the reason for the excessive volume of this structure is that three sets of single-phase switch tube groups are respectively set on three heat sinks 10, increasing the volume of the power module due to the influence of the heat sink 10.

Furthermore, the inventor discovered that this structure also has the problem of high stray inductance. The reason is that the input busbar 03 is set perpendicular to the capacitor busbar 01, causing the distance between the switch module located on the outside and the capacitor busbar 01 to be too long, which in turn leads to a long commutation loop and increased stray inductance.

To solve the above technical problems, this invention provides the following embodiments.

### Embodiment 1

This example provides a power module that mainly includes a heat sink 10, a capacitor module, and a power module.

The capacitor module includes a capacitor busbar 50 and a DC capacitor bank connected to each other. The capacitor busbar 50 has a connection part for connecting the power module. Referring to the background technology, the capacitor busbar 50 has a positive plate, a neutral plate, and a negative plate, with the three plates stacked and each having three input terminals. The power module can draw power from the capacitor busbar 50 by connecting to it, with the connecting part being the aforementioned connection part. Therefore, the location of the connection part on the capacitor busbar 50 is determined by the position where the power module is connected, and it can be considered that the part on the capacitor busbar 50 that forms a connection with the power module and the adjacent part are the connection part. It should be noted that the connection part should be flat to facilitate connection with the power module. Generally, the capacitor busbar 50 is also flat, and the connection part is formed on the capacitor busbar 50.

The power module includes an input busbar 31, an output busbar 32, and three single-phase switch tube groups 40. The input busbar 31 connects to the connection part of the capacitor busbar 50 and to each single-phase switch tube group 40. Each single-phase switch tube group 40 connects to an output busbar 32 to output single-phase AC power. Each single-phase switch tube group 40 includes several switch modules formed by combining switch tubes 20. The switch tubes 20 are IGBT devices, with three switch tubes 20 forming a switch module, and multiple switch modules in parallel forming a single-phase switch tube group 40. Each single-phase switch tube group 40 is used to output single-phase AC power. This power module has a total of three single-phase switch tube groups 40, which together output three-phase AC power. In this example, each single-phase switch tube group 40 includes four switch modules, totaling twelve switch tubes 20.

The switch tubes 20 in each switch module include input tubes 21 and output tubes 22, with two input tubes 21 and one output tube 22. The input end of the input tube 21 forms the input end of its corresponding switch module, and the output end of the output tube 22 forms the output end of its corresponding switch module.

Referring to the background technology, a connecting busbar 33 connects the input tube 21 and the output tube 22, which can be a copper busbar. The input ends of the two input tubes 21 connect to the connection part of the capacitor busbar 50 through the input busbar 31, and the output ends of the two input tubes 21 connect to the input end of the output tube 22 through the connecting busbar 33. The output end of the output tube 22 connects to the output busbar 32. Each output tube 22 in each single-phase switch tube group 40 connects to the same output busbar 32.

The input busbar 31 and the output busbar 32 are used to transport current in a hard-wired form and can be copper busbars or terminal posts. For example, when some input tubes 21 in a single-phase switch tube group are close to the connection part of the capacitor busbar 50, copper busbars are not required for connection, and terminal posts can be used instead.

The heat sink 10 is used to install the switch tubes 20. After the switch tubes 20 are installed on the heat sink 10, the excess heat can be carried away by the heat sink 10, preventing the switch tubes 20 from overheating during operation. Conventionally, the heat sink 10 can use an air-cooled heat sink as shown in the background technology, and in this example, it can also use an air-cooled heat sink. In this case, the side of the air-cooled heat sink 10 opposite the heat dissipation fins forms the mounting surface for the switch tubes 20.

However, as a preferred embodiment, this example uses a liquid-cooled heat sink. The liquid-cooled heat sink can provide higher cooling efficiency, allowing more switch tubes 20 to be stacked in a single liquid-cooled heat sink. The liquid-cooled heat sink is generally a plate-shaped component, with both sides forming mounting surfaces.

The layout of the switch tubes 20 in the power module mentioned above is described below.

As an optional embodiment, the three single-phase switch tube groups 40 are all installed on one heat sink 10. This effectively reduces the overall volume of the power module because it does not require multiple heat sinks 10 as described in the background technology. It is understood that in order to mount the three single-phase switch tube groups 40 on one heat sink 10, the heat sink 10 must have good heat dissipation performance. At this time, the liquid-cooled heat sink used in this embodiment may be a better choice.

Furthermore, in each single-phase switch tube group 40, the layout direction of each switch module is parallel to the connection part of the capacitor busbar 50. This ensures that in each single-phase switch tube group 40, the distance from each switch module to the capacitor busbar 50 is equal, avoiding the problem of inconsistent commutation loop lengths of switch modules at different positions in each single-phase switch tube group 40.

Furthermore, the three single-phase switch tube groups 40 are all installed on one mounting surface of the heat sink 10, and this mounting surface is parallel to the connection part. The mounting surface being parallel to the connection part can be seen as the flat heat sink 10 and the flat capacitor busbar 50 arranged in a stacked manner. When the mounting surface is located on the front side of the heat sink 10, it facilitates maintenance of the three single-phase switch modules. Moreover, when another side of the heat sink 10 forms another mounting surface, the other mounting surface of the heat sink 10 can be used for quick heat dissipation, improving heat dissipation efficiency. In this embodiment, the three single-phase switch tube groups 40 are installed on the front mounting surface of the heat sink 10. However, in other embodiments, the three single-phase switch tube groups 40 can also be installed on the rear mounting surface of the heat sink 10. When installed on the rear mounting surface, the layout of each switch tube 20 and input busbar 31, output busbar 32 can be arranged as described in this embodiment.

Furthermore, all the switch modules in the single-phase switch tube groups 40 are divided into two parts arranged on the upper and lower parts of the mounting surface. The switch modules in each part are arranged side by side in the left-right direction, and the input ends of the switch modules in the two parts face away from each other.

Furthermore, the three single-phase switch tube groups 40 are respectively the first phase 41, the second phase 42, and the third phase 43. The first phase 41 and the second phase 42 are arranged on the upper and lower parts of the mounting surface respectively, with their output ends facing each other and located in the middle of the mounting surface. Each of their output ends is connected to an output busbar 32. The third phase 43 is divided into the first part 43a and the second part 43b of the third phase according to the number of switch modules included. Both parts are arranged on the upper and lower parts of the mounting surface, with their output ends located in the middle of the mounting surface and connected to the same output busbar 32. It should be noted that "side by side" in this specification means that the positions of the input tubes 21 of each switch module correspond to each other in the left-right direction, and the positions of the output tubes 22 also correspond to each other in the left-right direction.

The following provides further explanation of the above content.

In this embodiment, the side of the liquid-cooled heat sink that faces away from the capacitor busbar 50 forms the mounting surface, and the power module is installed on this mounting surface. Therefore, the power module is also set away from the connection part of the capacitor busbar 50.

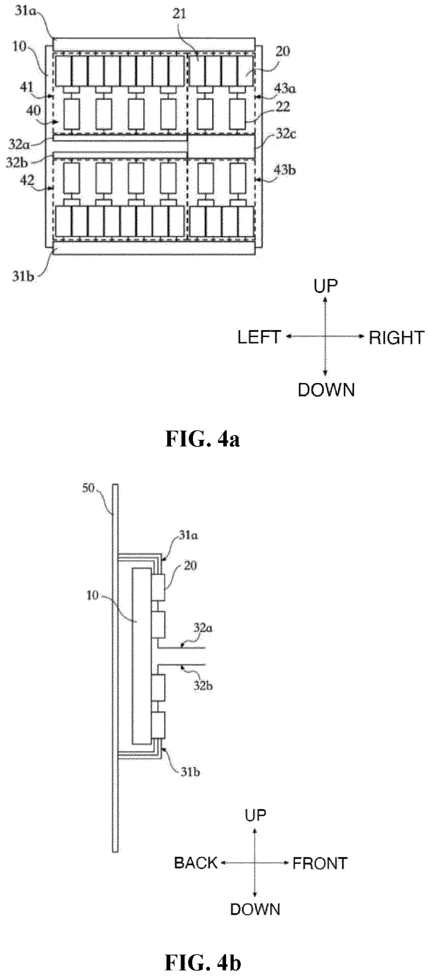

Referring to Fig. 4a, it shows the layout of the three single-phase switch tube groups 40 on the heat sink 10 and indicates the corresponding directions. At the same time, referring to Fig. 4b, it shows the structure of this layout in a side view and indicates the corresponding directions. It should be noted that the direction shown in Fig. 4a is when viewed from the front of the heat sink 10, facing the front mounting surface of the heat sink 10.

In this embodiment, each single-phase switch tube group 40 consists of four switch modules, and the three single-phase switch tube groups 40 are respectively the first phase 41, the second phase 42, and the third phase 43. The first phase 41 and the second phase 42 each include four side-by-side switch modules, and the third phase 43 is divided into the first part 43a and the second part 43b of the third phase, each part including two side-by-side switch modules.

In the first phase 41 and the second phase 42, the four switch modules are arranged side by side in the left-right direction, so the output ends and input ends of each switch module are also arranged side by side. At this time, the input ends of the four switch modules together form the input end of the single-phase switch tube group 40, and the output ends of the four switch modules together form the output end of the single-phase switch tube group 40.

In the third phase 43, the four switch modules are divided into two parts. The two switch modules in each part are arranged side by side in the left-right direction, so the output ends and input ends of each switch module in each part are also arranged side by side. At this time, the input ends of the two switch modules in each part together form the input end of that part, and the output ends of the two switch modules in each part together form the output end of that part.

Furthermore, the switch modules in the first phase 41 and the first part 43a of the third phase are arranged side by side; the switch modules in the second phase 42 and the second part 43b of the third phase are also arranged side by side.

Referring to Fig. 4a, the single-phase switch tube groups 40 of the first phase 41 and the second phase 42 are arranged symmetrically up and down. That is to say, the input and output ends of the first phase 41 are located at the top and bottom respectively, and the input and output ends of the second phase 42 are located at the bottom and top respectively, with their output ends facing each other and input ends facing away from each other. When installed on the heat sink 10, the input end of the first phase 41 corresponds to the upper edge of the heat sink 10, and the output end corresponds to the middle of the heat sink 10. The input end of the second phase 42 corresponds to the lower edge of the heat sink 10, and the output end corresponds to the middle of the heat sink 10. The third phase 43 is also arranged symmetrically up and down with the first part 43a and the second part 43b. That is to say, the input and output ends of the first part 43a of the third phase are located at the top and bottom respectively, and the input and output ends of the second part 43b of the third phase are located at the bottom and top respectively, with their output ends facing each other and input ends facing away from each other. When installed on the heat sink 10, the input end of the first part 43a of the third phase corresponds to the upper edge of the heat sink 10, and the output end corresponds to the middle of the heat sink 10. The input end of the second part 43b of the third phase corresponds to the lower edge of the heat sink 10, and the output end corresponds to the middle of the heat sink 10.

Referring to Fig. 4a, each single-phase switch tube group 40 is connected to the capacitor busbar 50 through the input busbar 31 and connected to an output busbar 32. Among them, the input ends of the single-phase switch tube groups 40 of the first phase 41 and the first part 43a of the third phase are located at the upper edge of the heat sink 10, so an input busbar first part 31a can be arranged along the upper edge of the heat sink 10; the input ends of the single-phase switch tube groups 40 of the second phase 42 and the second part 43b of the third phase are located at the lower edge of the heat sink 10, so an input busbar second part 31b can be arranged along the lower edge of the heat sink 10; the output end of the first phase 41 corresponds to an output busbar first part 32a, the output end of the second phase 42 corresponds to an output busbar second part 32b, and the output ends of the first part 43a and the second part 43b of the third phase are opposite, so a common output busbar third part 32c can be arranged accordingly.

Referring to Fig. 4b, the capacitor busbar 50 is located on the rear side of the heat sink 10, and the three single-phase switch tube groups 40 are installed on the front mounting surface of the heat sink 10. The extension direction of the input busbar 31 is parallel to the plate surface of the capacitor busbar 50. Thus, in each single-phase switch tube group 40, the distance from each switch module to the connection part of the capacitor busbar 50 through the input busbar 31 is equal, so the commutation loop lengths of each switch module are equal. Compared with the solution in the background technology, this distance is also shorter, reducing stray inductance and consequently switching losses.

Specifically, the input busbar first part 31a includes a positive plate, a neutral plate, and a negative plate. After the three are stacked, they are connected to the corresponding plates of the capacitor busbar 50. The input busbar second part 31b also includes a positive plate, a neutral plate, and a negative plate. After the three are stacked, they are connected to the corresponding plates of the capacitor busbar 50. Since the input ends of the three single-phase switch tube groups 40 are located at the upper and lower edges of the heat sink 10, the input busbar first part 31a and the input busbar second part 31b do not need to pass through the front mounting surface of the heat sink 10. Furthermore, the distances between the input busbar first part 31a, the input busbar second part 31b, and the capacitor busbar 50 are equal, leading to better balance in the DC side current loop.

The output busbar first part 32a, output busbar second part 32b, and output busbar third part 32c are all located in the middle of the front mounting surface of the heat sink 10. Their positions are centrally distributed, facilitating external output wiring.

The power module provided in this embodiment reduces the volume of the heat sink 10, thereby reducing the overall volume of the power module, and also reduces the generation of stray inductance.

### Embodiment 2

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

As an optional embodiment, the three single-phase switch tube groups 40 are divided into two parts to be respectively installed on the two mounting surfaces of the heat sink 10. In this embodiment, both sides of the liquid-cooled heat sink are formed as mounting surfaces, and the power module is installed on these two mounting surfaces. This reduces the volume of the heat sink 10, further improving the space utilization rate of the heat sink 10, and reducing the overall volume of the power module. Moreover, these two mounting surfaces are both parallel to the connection part. The mounting surface being parallel to the connection part can be seen as the flat heat sink 10 and the flat capacitor busbar 50 arranged in a stacked manner.

Furthermore, in each single-phase switch tube group 40, the switch modules are arranged side by side in the left-right direction. One complete single-phase switch tube group 40 is located on the front mounting surface of the heat sink 10, another complete single-phase switch tube group 40 is located on the rear mounting surface of the heat sink 10, and in the last single-phase switch tube group 40, the output tubes 22 of the switch modules are located on the front mounting surface of the heat sink 10, while the input tubes 21 of the switch modules are located on the rear mounting surface of the heat sink 10. It should be noted that in the last single-phase switch tube group 40, the output tubes 22 are arranged side by side in the left-right direction, and the input tubes 21 are also arranged side by side in the left-right direction.

The following provides further explanation of the above content.

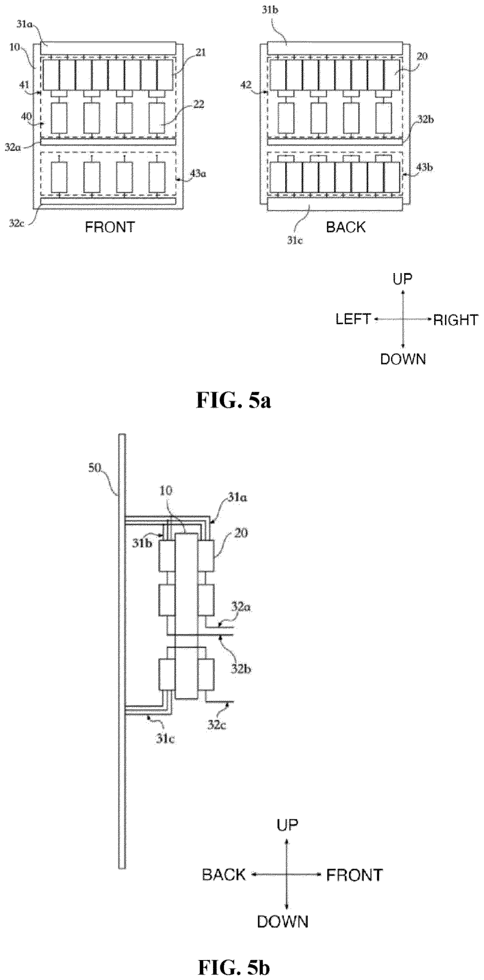

Refer to Fig. 5a, which shows the layout of the three single-phase switch tube groups 40 on the heat sink 10 in this embodiment, and indicates the corresponding directions. At the same time, refer to Fig. 5b, which shows the structure of this layout in a side view, and indicates the corresponding directions. It should be noted that the direction shown in Fig. 5a is when viewed from the front of the heat sink 10, facing the front mounting surface of the heat sink 10. In other words, the direction shown in Fig. 5a is only for indicating the front side view direction in Fig. 5a.

Refer to Fig. 5a. In this embodiment, each single-phase switch tube group 40 consists of four switch modules. The three single-phase switch tube groups 40 are respectively the first phase 41, the second phase 42, and the third phase 43. The first phase 41 and the second phase 42 each include four side-by-side switch modules, while the third phase 43 is divided into the first part 43a and the second part 43b of the third phase. The first part 43a of the third phase includes all the output tubes 22 of the switch modules in the single-phase switch tube group 40, and the second part 43b of the third phase includes all the input tubes 21 of the switch modules in the single-phase switch tube group 40.

Refer to Fig. 5a. The single-phase switch tube group 40 of the first phase 41 is located on the front mounting surface of the heat sink 10, the single-phase switch tube group 40 of the second phase 42 is located on the rear mounting surface of the heat sink 10, the first part 43a of the third phase is located on the front mounting surface of the heat sink 10, and the second part 43b of the third phase is located on the rear mounting surface of the heat sink 10.

In the first phase 41 and the second phase 42, the four switch modules are arranged side by side in the left-right direction, so the output ends and input ends of each switch module are also arranged side by side. At this time, the input ends of the four switch modules together form the input end of the single-phase switch tube group 40, and the output ends of the four switch modules together form the output end of the single-phase switch tube group 40. Moreover, the input and output ends of the single-phase switch tube groups 40 of the first phase 41 and the second phase 42 are respectively located at the top and bottom. When installed on the heat sink 10, the input end of the first phase 41 corresponds to the upper edge of the heat sink 10, and the output end corresponds to the middle of the heat sink 10. The input end of the second phase 42 corresponds to the lower edge of the heat sink 10, and the output end corresponds to the middle of the heat sink 10. The only difference is that one is on the front side of the heat sink 10, and the other is on the rear side of the heat sink 10.

The first part 43a of the third phase corresponds to the output tubes 22 of the switch modules in the single-phase switch tube group 40 of the third phase. These four output tubes 22 are arranged side by side in the left-right direction, and their output ends are also arranged side by side. At this time, the output ends of these four output tubes 22 together form the output end of the single-phase switch tube group 40. The second part 43b of the third phase corresponds to the input tubes 21 of the switch modules in the single-phase switch tube group 40 of the third phase. These eight input tubes 21 are arranged side by side in the left-right direction, with two input tubes 21 of the same switch module closely set. The input ends of these eight input tubes 21 are also arranged side by side. At this time, the input ends of these eight input tubes 21 together form the input end of the single-phase switch tube group 40. In the third phase 43, the input and output ends of the single-phase switch tube group 40 are both located at the bottom. When installed on the heat sink 10, the input and output ends of the single-phase switch tube group 40 both correspond to the upper edge of the heat sink 10, with the output end on the front side and the input end on the rear side.

Refer to Fig. 5a. Each single-phase switch tube group 40 is connected to the capacitor busbar 50 through the input busbar 31 and connected to an output busbar 32. Among them, the input ends of the single-phase switch tube groups 40 of the first phase 41 and the second phase 42 are located at the upper edge of the heat sink 10, so an input busbar first part 31a and an input busbar second part 31b can be arranged along the upper edge of the heat sink 10. The input busbar first part 31a and the input busbar second part 31b can be connected in parallel and then connected to the capacitor busbar 50. The input end of the second part 43b of the third phase is located at the lower edge of the heat sink 10, so an input busbar third part 31c can be arranged at the lower edge of the heat sink 10.

Refer to Fig. 5b. The input ends of the single-phase switch tube groups 40 of the first phase 41 and the second phase 42 are located at the middle of the heat sink 10, so an output busbar first part 32a and an output busbar second part 32b can be arranged at the middle of the heat sink 10. It should be noted that the output busbar first part 32a is located on the front side of the heat sink 10 and can directly output wiring externally, but the output busbar second part 32b is located on the rear side of the heat sink 10. If it is to output wiring externally, there must be enough space between the rear side mounting surface of the heat sink 10 and the capacitor busbar 50, which is not conducive to the overall commutation loop length of the power module. Therefore, an opening can be arranged in the middle of the heat sink 10, leading the output busbar second part 32b from the rear side of the heat sink 10 to the front side, facilitating external wiring of the output busbar second part 32b.

The output end of the first part 43a of the third phase is located at the lower edge of the heat sink 10, so an output busbar third part 32c can be arranged at the lower edge of the heat sink 10. In the third phase 43, the two input tubes 21 and output tubes 22 of each switch module are respectively located on both sides of the heat sink 10, so openings can be arranged at corresponding positions of the heat sink 10. The connecting busbar 33 connects the input tubes 21 and output tubes 22 of each switch module. For ease of processing, since the position of the connecting busbar 33 in the third phase 43 also corresponds to the middle of the heat sink 10, only one opening can be arranged in the middle of the heat sink 10, through which the connecting busbar 33 and the output busbar second part 32b can both pass.

Refer to Fig. 5b. The capacitor busbar 50 is located on the rear side of the heat sink 10, and the extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal. Compared with the solution in the background technology, this distance is also shorter, reducing stray inductance and consequently switching losses.

Specifically, the input busbar first part 31a, input busbar second part 31b, and input busbar third part 31c all include a positive plate, a neutral plate, and a negative plate. After the three are stacked, they are connected to the corresponding plates of the capacitor busbar 50. Since the input ends of the three single-phase switch tube groups 40 are located at the upper and lower edges of the heat sink 10, the input busbar first part 31a, second part, and third part do not need to pass through the front mounting surface of the heat sink 10. Among them, the distance between the input busbar second part 31b and the input busbar third part 31c to the capacitor busbar 50 is equal, leading to better balance in the DC side current loop. At the same time, although the current loop distance between the single-phase switch tube group 40 corresponding to the first phase 41 and the capacitor busbar 50 is slightly longer, the stray inductance is reduced by stacking the input busbars 31, meeting the usage requirements.

The power module provided in this embodiment, compared to Embodiment 1, by arranging the switch tubes 20 on both the front and rear sides of the heat sink 10, further reduces the volume of the heat sink 10, improves the surface space utilization rate of the heat sink 10, reduces the overall volume of the power module, and also reduces the generation of stray inductance.

### Embodiment 3

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

In this embodiment, a liquid-cooled heat sink is used. The liquid-cooled heat sink can provide higher cooling efficiency, allowing more switch tubes 20 to be stacked in one liquid-cooled heat sink. The liquid-cooled heat sink is generally a plate-shaped component, with both sides forming mounting surfaces.

As an optional embodiment, the three single-phase switch tube groups 40 are arranged parallel in the vertical direction.

In each single-phase switch tube group 40, the output tubes 22 of the switch modules are located on the front mounting surface of the heat sink 10, while the input tubes 21 of the switch modules are located on the rear mounting surface of the heat sink 10. In this embodiment, these two mounting surfaces are both parallel to the connection part. The mounting surface being parallel to the connection part can be seen as the flat heat sink 10 and the flat capacitor busbar 50 arranged in a stacked manner.

Corresponding to this layout method, for the "side by side arrangement" in a single-phase switch tube group 40, it means that in each single-phase switch tube group 40, the output tubes 22 are arranged side by side in the left-right direction, and the input tubes 21 are also arranged side by side in the left-right direction. The "parallel arrangement" mentioned above means that each single-phase switch tube group 40 is regarded as a whole, with the layout direction of the switch modules in each single-phase switch tube group 40 as the overall extension direction of the single-phase switch tube group 40. That is, each single-phase switch tube group 40 extends in the left-right direction, and under this premise, the three single-phase switch tube groups 40 are arranged parallel from top to bottom on the heat sink 10.

Furthermore, in each single-phase switch tube group 40, its output and input ends are both located below the single-phase switch tube group 40.

The following provides further explanation of the above content.

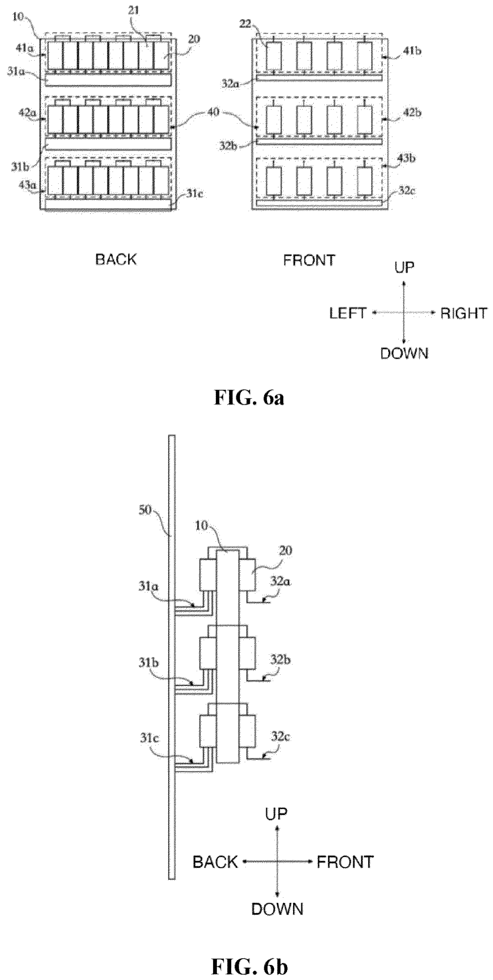

Refer to Fig. 6a, which shows the layout of the three single-phase switch tube groups 40 on the heat sink 10 in this embodiment, and indicates the corresponding directions. At the same time, refer to Fig. 6b, which shows the structure of this layout in a side view, and indicates the corresponding directions. It should be noted that the direction shown in Fig. 6a is when viewed from the front of the heat sink 10, facing the front mounting surface of the heat sink 10. In other words, the direction shown in Fig. 6a is only for indicating the front side view direction in Fig. 6a.

Refer to Fig. 6a. In this embodiment, each single-phase switch tube group 40 consists of four switch modules. The three single-phase switch tube groups 40 are respectively the first phase 41, the second phase 42, and the third phase 43. The first phase 41, the second phase 42, and the third phase 43 are each divided into two parts, respectively the first part 41a and the second part 41b of the first phase, the first part 42a and the second part 42b of the second phase, and the first part 43a and the second part 43b of the third phase. The first part of each phase corresponds to the input tubes 21 in the single-phase switch tube group 40, and the second part corresponds to the output tubes 22 in the single-phase switch tube group 40.

Refer to Fig. 6a. In each single-phase switch tube group 40, the input ends of the four switch modules together form the input end of the single-phase switch tube group 40, while the output ends of the four switch modules together form the output end of the single-phase switch tube group 40.

Among them, the first phase 41 is located at the upper position of the heat sink 10, the second phase 42 is located in the middle position of the heat sink 10, and the second phase 42 is located at the lower position of the heat sink 10. Correspondingly, the first part 41a of the first phase is located on the rear mounting surface of the upper position of the heat sink 10, and the second part 41b of the first phase is located on the front mounting surface of the upper position of the heat sink 10. The first part 41a and the second part 41b of the first phase are connected through the connecting busbar 33, which bypasses the upper edge of the heat sink 10. The first part 42a of the second phase is located on the rear mounting surface of the middle position of the heat sink 10, and the second part 42b of the second phase is located on the front mounting surface of the middle position of the heat sink 10. The first part 42a and the second part 42b of the second phase are connected through the connecting busbar 33. In this case, an opening can be arranged at the corresponding position of the heat sink 10, and the connecting busbar 33 can pass through the opening to connect the first part 42a and the second part 42b of the second phase. The first part 43a of the third phase is located on the rear mounting surface of the lower position of the heat sink 10, and the second part 43b of the third phase is located on the front mounting surface of the lower position of the heat sink 10. The first part 43a and the second part 43b of the third phase are connected through the connecting busbar 33. Similarly, an opening can be arranged at the corresponding position of the heat sink 10, and the connecting busbar 33 can pass through the opening to connect the first part 43a and the second part 43b of the third phase.

Refer to Fig. 6a. Each single-phase switch tube group 40 is connected to the capacitor busbar 50 through the input busbar 31 and connected to an output busbar 32. Among them, the input end of the first phase 41 is connected to the input busbar first part 31a, and the input busbar first part 31a is located below the first part 41a of the first phase; the output end of the first phase 41 is connected to the output busbar first part 32a, and the output busbar first part 32a is located below the second part 41b of the first phase. The input end of the second phase 42 is connected to the input busbar second part 31b, and the input busbar second part 31b is located below the first part 42a of the second phase; the output end of the second phase 42 is connected to the output busbar second part 32b, and the output busbar second part 32b is located below the second part 42b of the second phase. The input end of the third phase 43 is connected to the input busbar third part 31c, and the input busbar third part 31c is located below the first part 43a of the third phase; the output end of the third phase 43 is connected to the output busbar third part 32c, and the output busbar third part 32c is located below the second part 43b of the third phase.

Refer to Fig. 6b. The capacitor busbar 50 is located on the rear side of the heat sink 10, and the extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Specifically, the input busbar first part 31a, input busbar second part 31b, and input busbar third part 31c all include a positive plate, a neutral plate, and a negative plate. After the three are stacked, they are connected to the corresponding plates of the capacitor busbar 50. Since the input ends of the three single-phase switch tube groups 40 are located on the rear side of the heat sink 10, the input busbar first part 31a, second part, and third part can be directly connected to the capacitor busbar 50. Moreover, the distance from the input end of each single-phase switch tube group 40 to the capacitor busbar 50 is equal, improving the balance of the DC side current loop. At the same time, the output ends of each single-phase switch tube group 40 are located on the front side of the heat sink 10, making it easy for the output busbar first part 32a, second part, and third part to output wiring externally.

The power module provided in this embodiment, compared to Embodiment 1, by arranging the switch tubes 20 on both the front and rear sides of the heat sink 10, further reduces the volume of the heat sink 10, improves the surface space utilization rate of the heat sink 10, reduces the overall volume of the power module, and also reduces the generation of stray inductance.

Furthermore, in this embodiment, the number of heat sinks 10 is one. However, in other embodiments, the number of heat sinks 10 can be set to three, arranged vertically. Each heat sink 10 corresponds to a complete single-phase switch tube group 40, and the wiring method of the single-phase switch tube groups 40 can refer to the wiring method of each single-phase switch tube group 40 in this embodiment. However, when using three heat sinks 10, the connecting busbar 33 in each single-phase switch tube group 40 can directly bypass the upper or lower edge of the heat sink 10 in which it is located. Using three heat sinks 10 reduces the cooling capacity requirements of a single heat sink 10, reducing the cost of the heat sink 10, and also facilitates wiring and maintenance of the single-phase switch tube groups on each heat sink 10.

### Embodiment 4

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

In this embodiment, a liquid-cooled heat sink is used. The liquid-cooled heat sink can provide higher cooling efficiency, allowing more switch tubes 20 to be stacked in one liquid-cooled heat sink. The liquid-cooled heat sink is generally a plate-shaped component, with both sides forming mounting surfaces.

In this embodiment, the output tubes 22 of the switch modules in each single-phase switch tube group 40 are located on the front mounting surface of the heat sink 10, while the input tubes 21 of the switch modules are located on the rear mounting surface of the heat sink 10. In this embodiment, these two mounting surfaces are both parallel to the connection part. The mounting surface being parallel to the connection part can be seen as the flat heat sink 10 and the flat capacitor busbar 50 arranged in a stacked manner.

Corresponding to this layout method, the "side by side arrangement" mentioned above means that in each single-phase switch tube group 40, the output tubes 22 are arranged side by side in the left-right direction, and the input tubes 21 are also arranged side by side in the left-right direction. The "parallel arrangement" mentioned above means that each single-phase switch tube group 40 is regarded as a whole, with the layout direction of the switch modules in each single-phase switch tube group 40 as the overall extension direction of the single-phase switch tube group 40. That is, each single-phase switch tube group 40 extends in the left-right direction, and under this premise, the three single-phase switch tube groups 40 are arranged parallel from top to bottom on the heat sink 10.

Furthermore, in the two single-phase switch tube groups 40 located at the top, the output and input ends are both located below the respective single-phase switch tube groups 40; in the two single-phase switch tube groups 40 located at the bottom, the output and input ends are both located above the respective single-phase switch tube groups 40.

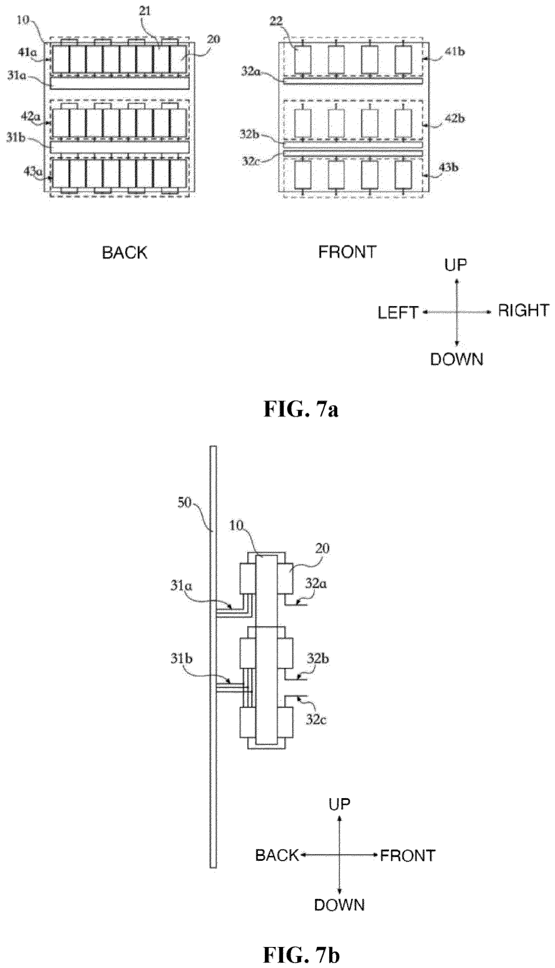

Refer to Fig. 7a, which shows the layout of the three single-phase switch tube groups 40 on the heat sink 10 in this embodiment, and indicates the corresponding directions. At the same time, refer to Fig. 7b, which shows the structure of this layout in a side view, and indicates the corresponding directions. It should be noted that the direction shown in Fig. 7a is when viewed from the front of the heat sink 10, facing the front mounting surface of the heat sink 10. In other words, the direction shown in Fig. 7a is only for indicating the front side view direction in Fig. 7a.

Refer to Fig. 7a. In this embodiment, each single-phase switch tube group 40 consists of four switch modules. The three single-phase switch tube groups 40 are respectively the first phase 41, the second phase 42, and the third phase 43. The first phase 41, the second phase 42, and the third phase 43 are each divided into two parts, respectively the first part 41a and the second part 41b of the first phase, the first part 42a and the second part 42b of the second phase, and the first part 43a and the second part 43b of the third phase. The first part of each phase corresponds to the input tubes 21 in the single-phase switch tube group 40, and the second part corresponds to the output tubes 22 in the single-phase switch tube group 40.

Refer to Fig. 7a. In each single-phase switch tube group 40, the input ends of the four switch modules together form the input end of the single-phase switch tube group 40, while the output ends of the four switch modules together form the output end of the single-phase switch tube group 40.

Among them, the first phase 41 is located at the upper position of the heat sink 10, the second phase 42 is located in the middle position of the heat sink 10, and the third phase 43 is located at the lower position of the heat sink 10. Correspondingly, the first part 41a of the first phase is located on the rear mounting surface of the upper position of the heat sink 10, and the second part 41b of the first phase is located on the front mounting surface of the upper position of the heat sink 10. The first part 41a and the second part 41b of the first phase are connected through the connecting busbar 33, which bypasses the upper edge of the heat sink 10. The first part 42a of the second phase is located on the rear mounting surface of the middle position of the heat sink 10, and the second part 42b of the second phase is located on the front mounting surface of the middle position of the heat sink 10. The first part 42a and the second part 42b of the second phase are connected through the connecting busbar 33. In this case, an opening can be arranged at the corresponding position of the heat sink 10, and the connecting busbar 33 can pass through the opening to connect the first part 42a and the second part 42b of the second phase. The first part 43a of the third phase is located on the rear mounting surface of the lower position of the heat sink 10, and the second part 43b of the third phase is located on the front mounting surface of the lower position of the heat sink 10. The first part 43a and the second part 43b of the third phase are connected through the connecting busbar 33. Similarly, an opening can be arranged at the corresponding position of the heat sink 10, and the connecting busbar 33 can pass through the opening to connect the first part 43a and the second part 43b of the third phase.

Refer to Fig. 7a. Each single-phase switch tube group 40 is connected to the capacitor busbar 50 through the input busbar 31 and connected to an output busbar 32. Among them, the input end of the first phase 41 is connected to the input busbar first part 31a, and the input busbar first part 31a is located below the first part 41a of the first phase; the output end of the first phase 41 is connected to the output busbar first part 32a, and the output busbar first part 32a is located below the second part 41b of the first phase. The input end of the second phase 42 is connected to the input busbar second part 31b, and the input busbar second part 31b is located below the first part 42a of the second phase; the output end of the second phase 42 is connected to the output busbar second part 32b, and the output busbar second part 32b is located below the second part 42b of the second phase. The input end of the third phase 43 is connected to the input busbar third part 31c, and the input busbar third part 31c is located above the first part 43a of the third phase; the output end of the third phase 43 is connected to the output busbar third part 32c, and the output busbar third part 32c is located above the second part 43b of the third phase.

Refer to Fig. 7b. The capacitor busbar 50 is located on the rear side of the heat sink 10, and the extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Specifically, the input busbar first part 31a, input busbar second part 31b, and input busbar third part 31c all include a positive plate, a neutral plate, and a negative plate. After the three are stacked, they are connected to the corresponding plates of the capacitor busbar 50. Since the input ends of the three single-phase switch tube groups 40 are located on the rear side of the heat sink 10, the input busbar first part 31a, second part, and third part can be directly connected to the capacitor busbar 50. Moreover, the distance from the input end of each single-phase switch tube group 40 to the capacitor busbar 50 is equal, improving the balance of the DC side current loop. At the same time, the output ends of each single-phase switch tube group 40 are located on the front side of the heat sink 10, making it easy for the output busbar first part 32a, second part, and third part to output wiring externally.

Compared to Embodiment 3, the input ends of the first part 42a of the second phase and the first part 43a of the third phase can be connected in parallel and then connected to the capacitor busbar 50, reducing the total length of the input busbar second part 31b and the input busbar third part 31c. This helps reduce stray inductance and lowers the cost.

The power module provided in this embodiment, compared to Embodiment 1, by arranging the switch tubes 20 on both the front and rear sides of the heat sink 10, further reduces the volume of the heat sink 10, improves the surface space utilization rate of the heat sink 10, reduces the overall volume of the power module, and also reduces the generation of stray inductance.

### Embodiment 5

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

Conventionally, the heat sink 10 can use an air-cooled heat sink as shown in the background technology. In this embodiment, an air-cooled heat sink can also be used. In this case, the side of the air-cooled heat sink 10 opposite the heat dissipation fins forms the mounting surface for the switch tubes 20. However, as a preferred embodiment, this embodiment uses a liquid-cooled heat sink. The liquid-cooled heat sink can provide higher cooling efficiency, allowing more switch tubes 20 to be stacked in one liquid-cooled heat sink. The liquid-cooled heat sink is generally a plate-shaped component, with both sides forming mounting surfaces.

As an optional embodiment, in the power module, each single-phase switch tube group is arranged side by side on the heat sink 10, and the layout direction of each single-phase switch tube group is parallel to the connection part; in each single-phase switch tube group, the layout direction of each switch module is consistent with the layout direction of each single-phase switch tube group. In each single-phase switch tube group 40, the layout direction of each switch module is parallel to the connection part of the capacitor busbar 50. This ensures that in each single-phase switch tube group 40, the distance from each switch module to the capacitor busbar 50 is equal, avoiding the problem of inconsistent commutation loop lengths of switch modules at different positions in each single-phase switch tube group 40.

Furthermore, the three single-phase switch tube groups 40 are all installed on one mounting surface of the heat sink 10. In this embodiment, the mounting surface is parallel to the connection part. The mounting surface being parallel to the connection part can be seen as the flat heat sink 10 and the flat capacitor busbar 50 arranged in a stacked manner. When the mounting surface is located on the front side of the heat sink 10, it facilitates maintenance of the three single-phase switch modules, and when another mounting surface is formed on the other side of the heat sink 10, it can be used for quick heat dissipation, improving heat dissipation efficiency. In this embodiment, the three single-phase switch tube groups 40 are installed on the front mounting surface of the heat sink 10. However, in other embodiments, the three single-phase switch tube groups 40 can also be installed on the rear mounting surface of the heat sink 10. When installed on the rear mounting surface, the layout of each switch tube 20, input busbar 31, and output busbar 32 can be arranged as described in this embodiment.

The following provides further explanation of the above content.

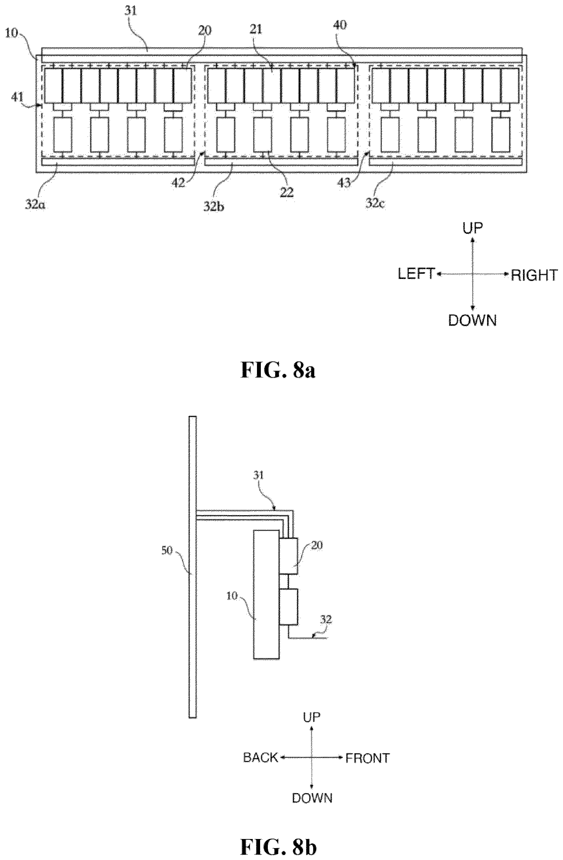

Specifically, refer to Fig. 8a, which shows the layout of the three single-phase switch tube groups 40 on the heat sink 10 in this embodiment, and indicates the corresponding directions. At the same time, refer to Fig. 8b, which shows the structure of this layout in a side view, and indicates the corresponding directions. It should be noted that the direction shown in Fig. 8a is when viewed from the front of the heat sink 10, facing the front surface of the heat sink 10.

In this embodiment, each single-phase switch tube group 40 consists of four switch modules. The three single-phase switch tube groups 40 are respectively the first phase 41, the second phase 42, and the third phase 43, each including four switch modules arranged side by side in the left-right direction. In each switch module, the output ends and input ends are also arranged side by side. At this time, the input ends of the four switch modules together form the input end of the single-phase switch tube group 40, and the output ends of the four switch modules together form the output end of the single-phase switch tube group 40.

Refer to Fig. 8a. Each single-phase switch tube group 40 is connected to the capacitor busbar 50 through the input busbar 31, and each is connected to an output busbar 32. The input and output ends of each phase of the three single-phase switch tube groups 40 are respectively located at the top and bottom, so an input busbar 31 can be arranged along the upper edge of the heat sink 10, connecting all three single-phase switch tube groups 40, and three output busbars 32 can be arranged along the lower edge of the heat sink 10, corresponding to the first phase 41, the second phase 42, and the third phase 43, respectively being the output busbar first part 32a, output busbar second part 32b, and output busbar third part 32c.

Refer to Fig. 8b. The capacitor busbar 50 is located on the rear side of the heat sink 10, and the three single-phase switch tube groups 40 are installed on the front mounting surface of the heat sink 10. The extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Specifically, the input busbar first part 31a includes a positive plate, a neutral plate, and a negative plate. After the three are stacked, they are connected to the corresponding plates of the capacitor busbar 50. The input busbar 31 also includes a positive plate, a neutral plate, and a negative plate, which are stacked and connected to the corresponding plates of the capacitor busbar 50. Since the input ends of the three single-phase switch tube groups 40 are located at the upper edge of the heat sink 10, only one input busbar 31 is needed to connect to the capacitor busbar 50. Therefore, the distance from each single-phase switch tube group 40 to the capacitor busbar 50 is equal, ensuring the consistency of the current loop distance between each single-phase switch tube group 40 and the capacitor busbar 50, and regardless of the current direction of the capacitor busbar 50, the timing when it reaches each single-phase switch tube group 40 is also equal, resulting in the best current loop balance.

The output busbar first part 32a, output busbar second part 32b, and output busbar third part 32c are all located below the front mounting surface of the heat sink 10, with their positions centrally distributed, facilitating external output wiring.

The power module provided in this embodiment, compared to Embodiments 1 to 4, improves the current loop balance between the capacitor busbar 50 and each single-phase switch tube group 40 by arranging the single-phase switch tube groups 40 side by side, ensuring the consistency of the current loop distance between the three single-phase switch tube groups 40 and the capacitor busbar 50, while also reducing stray inductance.

### Embodiment 6

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

In this embodiment, a liquid-cooled heat sink is used. The liquid-cooled heat sink can provide higher cooling efficiency, allowing more switch tubes 20 to be stacked in one liquid-cooled heat sink. The liquid-cooled heat sink is generally a plate-shaped component, with both sides forming mounting surfaces.

As an optional embodiment, the three single-phase switch tube groups 40 are divided into two parts to be respectively installed on the two mounting surfaces of the heat sink 10. On each mounting surface, the switch modules are arranged side by side in the left-right direction. In this embodiment, these two mounting surfaces are both parallel to the connection part. The mounting surface being parallel to the connection part can be seen as the flat heat sink 10 and the flat capacitor busbar 50 arranged in a stacked manner. This reduces the volume of the heat sink 10, further improves the space utilization rate of the heat sink 10, and reduces the overall volume of the power module.

The following provides further explanation of the above content.

One complete single-phase switch tube group 40 is located on the front mounting surface of the heat sink 10, another complete single-phase switch tube group 40 is located on the rear mounting surface of the heat sink 10, and in the last single-phase switch tube group 40, the switch modules are evenly divided into two parts, with each part arranged side by side. These two parts are respectively located on the front and rear mounting surfaces of the heat sink 10.

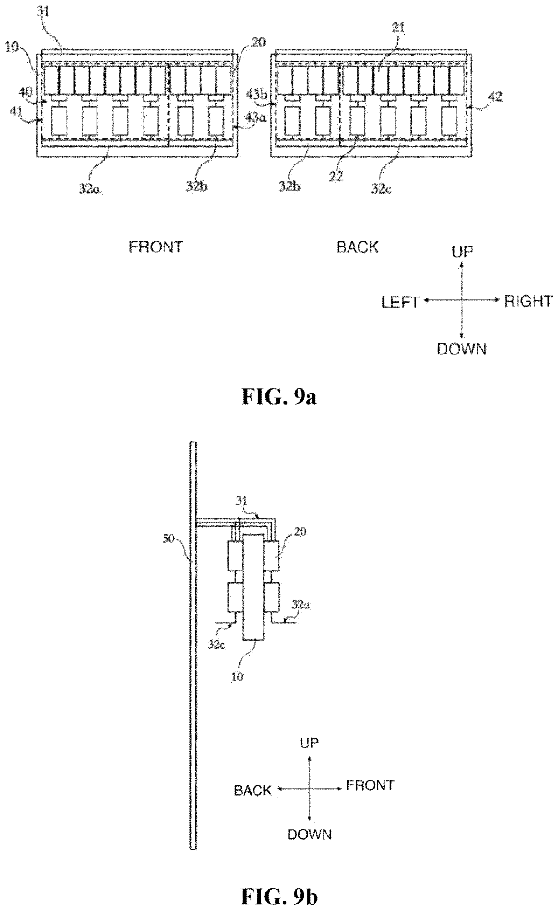

Refer to Fig. 9a, which shows the layout of the three single-phase switch tube groups 40 on the heat sink 10 in this embodiment, and indicates the corresponding directions. At the same time, refer to Fig. 9b, which shows the structure of this layout in a side view, and indicates the corresponding directions. It should be noted that the direction shown in Fig. 9a is when viewed from the front of the heat sink 10, facing the front mounting surface of the heat sink 10.

In this embodiment, each single-phase switch tube group 40 consists of four switch modules. The three single-phase switch tube groups 40 are respectively the first phase 41, the second phase 42, and the third phase 43. The first phase 41 and the second phase 42 each include four switch modules arranged side by side, while the third phase 43 is divided into the first part 43a and the second part 43b of the third phase, each part including two switch modules arranged side by side. The first phase 41 and the first part 43a of the third phase are located on the front mounting surface of the heat sink 10, while the second phase 42 and the second part 43b of the third phase are located on the rear mounting surface of the heat sink 10. On the front mounting surface of the heat sink 10, the first phase 41 and the first part 43a of the third phase are arranged side by side in the left-right direction; on the rear mounting surface of the heat sink 10, the second phase 42 and the second part 43b of the third phase are arranged side by side in the left-right direction.

In the first phase 41 and the second phase 42, the four switch modules are arranged side by side in the left-right direction, so the output ends and input ends of each switch module are also arranged side by side. At this time, the input ends of the four switch modules together form the input end of the single-phase switch tube group 40, and the output ends of the four switch modules together form the output end of the single-phase switch tube group 40.

In the third phase 43, the four switch modules are divided into two parts. The two switch modules in each part are arranged side by side in the left-right direction, so the output ends and input ends of each switch module in each part are also arranged side by side. At this time, the input ends of the two switch modules in each part together form the input end of that part, and the output ends of the two switch modules in each part together form the output end of that part.

Refer to Fig. 9a. The input ends of the first phase 41, the second phase 42, and the third phase 43 are all located at the top. When installed on the heat sink 10, the input ends of the first phase 41, the second phase 42, and the third phase 43 all correspond to the upper edge of the heat sink 10, and the output ends correspond to the lower edge of the heat sink 10. At the same time, each single-phase switch tube group 40 is connected to the capacitor busbar 50 through the input busbar 31, and each is connected to an output busbar 32. Therefore, an input busbar 31 can be arranged along the upper edge of the heat sink 10, connecting the input ends of the first phase 41, the second phase 42, and the third phase 43; three output busbars 32 can be arranged along the lower edge of the heat sink 10, corresponding to the first phase 41, the second phase 42, and the third phase 43, respectively being the output busbar first part 32a, output busbar second part 32b, and output busbar third part 32c.

For the output busbar third part 32c, since the third phase 43 is divided into the first part 43a and the second part 43b of the third phase, with the two parts respectively located on the front and rear mounting surfaces of the heat sink 10, and the output busbar third part 32c needs to connect the output ends of both the first part 43a and the second part 43b of the third phase, the output busbar third part 32c can bypass the right edge of the heat sink 10, thereby connecting the output ends of both the first part 43a and the second part 43b of the third phase.

Refer to Fig. 9b. The capacitor busbar 50 is located on the rear side of the heat sink 10, and the three single-phase switch tube groups 40 are installed on the front and rear mounting surfaces of the heat sink 10. The extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Refer to Fig. 9b. Since the input ends of the three single-phase switch tube groups 40 are located at the upper edge of the heat sink 10, only one input busbar 31 is needed to connect to the capacitor busbar 50. Therefore, the distance from each single-phase switch tube group 40 to the capacitor busbar 50 is equal, ensuring the consistency of the current loop distance between each single-phase switch tube group 40 and the capacitor busbar 50. Regardless of the current direction of the capacitor busbar 50, the timing when it reaches each single-phase switch tube group 40 is also equal, resulting in the best current loop balance. At the same time, refer to Fig. 9b. The input end of the second phase 42 can be connected in parallel with the input busbar 31 that connects to the input end of the first phase 41 before connecting to the capacitor busbar 50, reducing the total length of the input busbar 31, lowering manufacturing costs, and reducing stray inductance.

The output busbar first part 32a, output busbar second part 32b, and output busbar third part 32c are all located below the lower edge of the heat sink 10, with their positions centrally distributed, facilitating external output wiring.

The power module provided in this embodiment, compared to Embodiments 1 to 4, improves the current loop balance between the capacitor busbar 50 and each single-phase switch tube group 40 by arranging the single-phase switch tube groups 40 side by side, ensuring the consistency of the current loop distance between the three single-phase switch tube groups 40 and the capacitor busbar 50, while also reducing stray inductance. Compared to Embodiment 5, by arranging the switch tubes 20 on both the front and rear sides of the heat sink 10, this embodiment further reduces the volume of the heat sink 10, improves the surface space utilization rate of the heat sink 10, and reduces the overall volume of the power module.

### Embodiment 7

This embodiment provides a power module that mainly includes a heat sink 10, a capacitor module, and a power module.

Refer to Embodiment 1 for the introduction of the capacitor module and power module, with differences described below.

The layout of the switch tubes 20 in the power module mentioned above is described below.

As an optional embodiment, the three single-phase switch tube groups 40 are respectively installed on three heat sinks 10. This reduces the cooling capacity requirement for each heat sink 10, thereby reducing the cost of the heat sinks 10.

Furthermore, in the power module, each single-phase switch tube group is arranged side by side on the heat sink 10, and the layout direction of each single-phase switch tube group is parallel to the connection part; in each single-phase switch tube group, the layout direction of each switch module is consistent with the layout direction of each single-phase switch tube group. In each single-phase switch tube group 40, the layout direction of each switch module is parallel to the connection part of the capacitor busbar 50. This ensures that in each single-phase switch tube group 40, the distance from each switch module to the capacitor busbar 50 is equal, avoiding the problem of inconsistent commutation loop lengths of switch modules at different positions in each single-phase switch tube group 40.

Furthermore, the three single-phase switch tube groups 40 are all installed on one mounting surface of the heat sink 10. In this embodiment, the mounting surface is parallel to the connection part. The mounting surface being parallel to the connection part can be seen as the flat heat sink 10 and the flat capacitor busbar 50 arranged in a stacked manner. When the mounting surface is located on the front side of the heat sink 10, it facilitates maintenance of the three single-phase switch modules, and when another mounting surface is formed on the other side of the heat sink 10, it can be used for quick heat dissipation, improving heat dissipation efficiency. In this embodiment, the three single-phase switch tube groups 40 are installed on the front mounting surface of the heat sink 10. However, in other embodiments, the three single-phase switch tube groups 40 can also be installed on the rear mounting surface of the heat sink 10. When installed on the rear mounting surface, the layout of each switch tube 20, input busbar 31, and output busbar 32 can be arranged as described in this embodiment.

The following provides further explanation of the above content.

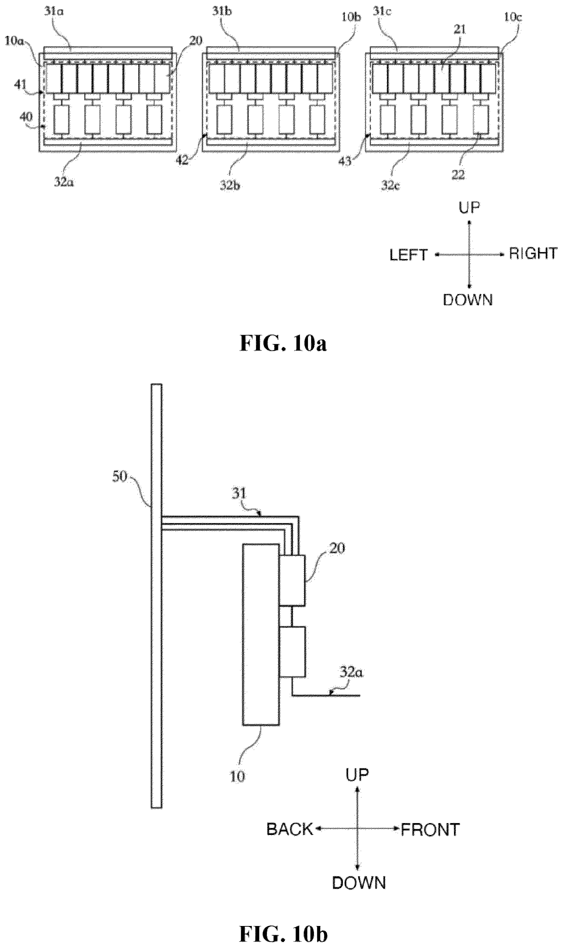

Specifically, refer to Fig. 10a, which shows the layout of the three single-phase switch tube groups 40 on the heat sink 10 in this embodiment, and indicates the corresponding directions. At the same time, refer to Fig. 10b, which shows the structure of this layout in a side view, and indicates the corresponding directions. It should be noted that the direction shown in Fig. 10a is when viewed from the front of the heat sink 10, facing the front mounting surface of the heat sink 10.

In this embodiment, the heat sink 10 includes the first sub-heat sink 10a, the second sub-heat sink 10b, and the third sub-heat sink 10c, arranged side by side in the left-right direction. In this embodiment, the heat sink 10 uses a liquid-cooled heat sink.

In this embodiment, each single-phase switch tube group 40 consists of four switch modules. The three single-phase switch tube groups 40 are respectively the first phase 41, the second phase 42, and the third phase 43. The first phase 41, the second phase 42, and the third phase 43 each include four switch modules arranged side by side in the left-right direction. In each switch module, the output ends and input ends are also arranged side by side. At this time, the input ends of the four switch modules together form the input end of the single-phase switch tube group 40, and the output ends of the four switch modules together form the output end of the single-phase switch tube group 40.

Refer to Fig. 10a. In each single-phase switch tube group 40, the arrangement direction of the four switch modules corresponds to the extension direction of the single-phase switch tube group 40, and also corresponds to the extension direction of the heat sink 10. In this embodiment, the single-phase switch tube group 40 extends in the left-right direction, and each heat sink 10 also extends in the left-right direction. The three single-phase switch modules arranged side by side in the left-right direction can be understood as the three single-phase switch tube groups 40 arranged in a line along their extension direction, and the three heat sinks 10 arranged in a line along their extension direction.

Refer to Fig. 10a. Each single-phase switch tube group 40 is connected to the capacitor busbar 50 through the input busbar 31, and each is connected to an output busbar 32. The input and output ends of each phase of the three single-phase switch tube groups 40 are respectively located at the top and bottom, so an input busbar 31 can be arranged along the upper edge of each heat sink 10, corresponding to the first phase 41, the second phase 42, and the third phase 43, respectively being the input busbar first part 31a, input busbar second part 31b, and input busbar third part 31c; at the same time, three output busbars 32 can be arranged along the lower edge of each heat sink 10, corresponding to the first phase 41, the second phase 42, and the third phase 43, respectively being the output busbar first part 32a, output busbar second part 32b, and output busbar third part 32c.

Refer to Fig. 10b. The capacitor busbar 50 is located on the rear side of the heat sink 10, and the three single-phase switch tube groups 40 are installed on the front mounting surface of the heat sink 10. The extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Specifically, the input busbar first part 31a includes a positive plate, a neutral plate, and a negative plate. After the three are stacked, they are connected to the corresponding plates of the capacitor busbar 50. The input busbar 31 also includes a positive plate, a neutral plate, and a negative plate, which are stacked and connected to the corresponding plates of the capacitor busbar 50. Since the input ends of the three single-phase switch tube groups 40 are located at the upper edges of their respective heat sinks 10, three input busbars 31 are needed to connect to the capacitor busbar 50. However, since the three single-phase switch tube groups 40 are arranged side by side in the left-right direction, the distance from each single-phase switch tube group 40 to the capacitor busbar 50 is equal, ensuring the consistency of the current loop distance between each single-phase switch tube group 40 and the capacitor busbar 50. Regardless of the current direction of the capacitor busbar 50, the timing when it reaches each single-phase switch tube group 40 is also equal, resulting in the best current loop balance.

The output busbar first part 32a, output busbar second part 32b, and output busbar third part 32c are all located below the front mounting surface of the heat sink 10, with their positions centrally distributed, facilitating external output wiring.

The power module provided in this embodiment, compared to Embodiments 1 to 4, improves the current loop balance between the capacitor busbar 50 and each single-phase switch tube group 40 by arranging the single-phase switch tube groups 40 side by side, ensuring the consistency of the current loop distance between the three single-phase switch tube groups 40 and the capacitor busbar 50, while also reducing stray inductance.

### Embodiment 8

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

As an optional embodiment, the three single-phase switch tube groups 40 are divided into two parts to be respectively installed on the two mounting surfaces of each heat sink 10. On each mounting surface, the switch modules are arranged side by side in the left-right direction. In this embodiment, these two mounting surfaces are both parallel to the connection part. The mounting surface being parallel to the connection part can be seen as the flat heat sink 10 and the flat capacitor busbar 50 arranged in a stacked manner. This reduces the volume of the heat sink 10, further improves the space utilization rate of the heat sink 10, and reduces the overall volume of the power module.

The following provides further explanation of the above content.

Each single-phase switch tube group 40 is evenly divided into two parts, with each part's switch modules arranged side by side. These two parts are respectively located on the front and rear mounting surfaces of the heat sink 10.

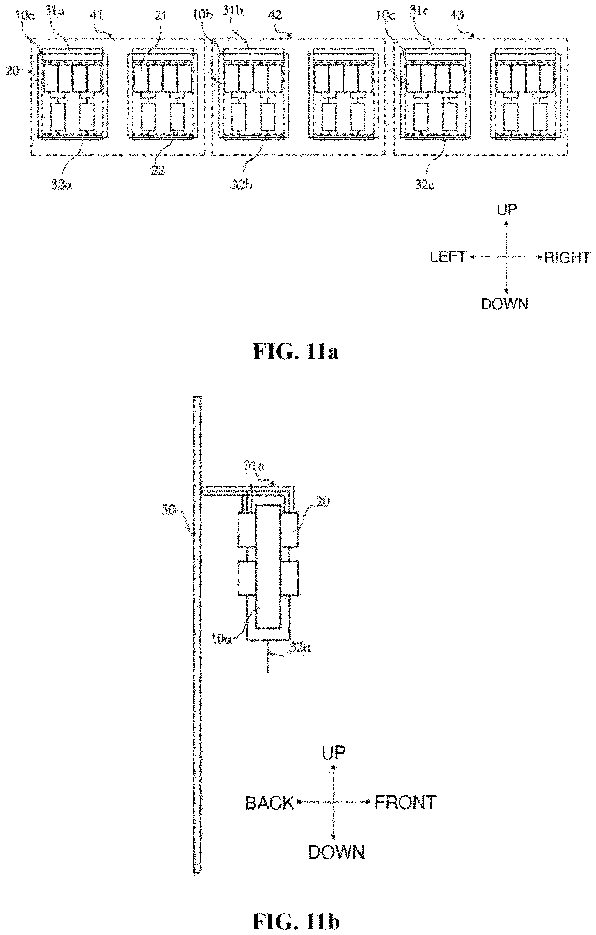

Refer to Fig. 11a, which shows the layout of the three single-phase switch tube groups 40 on the heat sink 10 in this embodiment, and indicates the corresponding directions. At the same time, refer to Fig. 11b, which shows the structure of this layout in a side view, and indicates the corresponding directions. It should be noted that the direction shown in Fig. 11a is when viewed from the front of the heat sink 10, facing the front mounting surface of the heat sink 10. In each single-phase switch tube group 40, the left part is the front side, and the right part is the rear side.

Refer to Fig. 11a. In this embodiment, the heat sink 10 includes the first sub-heat sink 10a, the second sub-heat sink 10b, and the third sub-heat sink 10c, arranged side by side in the left-right direction. In this embodiment, the heat sink 10 uses a liquid-cooled heat sink.

In this embodiment, each single-phase switch tube group 40 consists of four switch modules. The three single-phase switch tube groups 40 are respectively the first phase 41, the second phase 42, and the third phase 43. In each phase, the four switch modules are evenly divided into two parts, with each part's two switch modules arranged side by side. In each part, the output ends and input ends of the two switch modules are also arranged side by side. At this time, the input ends of the two switch modules in each part together form the input end of that part, and the output ends of the two switch modules in each part together form the output end of that part.

In this embodiment, the first phase 41 is divided into the first part 41a and the second part 41b, the second phase 42 is divided into the first part 42a and the second part 42b, and the third phase 43 is divided into the first part 43a and the second part 43b. The first parts of the first phase 41, the second phase 42, and the third phase 43 are all located on the front mounting surfaces of their respective heat sinks 10, while the second parts of the first phase 41, the second phase 42, and the third phase 43 are all located on the rear mounting surfaces of their respective heat sinks 10. The input ends of the first and second parts of each phase are located at the top, and the output ends are located at the bottom. When installed on the heat sinks 10, the input ends of the first phase 41, the second phase 42, and the third phase 43 correspond to the upper edges of their respective heat sinks 10, and the output ends correspond to the lower edges of their respective heat sinks 10.

Each single-phase switch tube group 40 is connected to the capacitor busbar 50 through the input busbar 31, and each is connected to an output busbar 32. The input and output ends of each phase of the three single-phase switch tube groups 40 are respectively located at the top and bottom. Therefore, an input busbar 31 can be arranged along the upper edge of each heat sink 10, corresponding to the first phase 41, the second phase 42, and the third phase 43, respectively being the input busbar first part 31a, input busbar second part 31b, and input busbar third part 31c. At the same time, three output busbars 32 can be arranged along the lower edge of each heat sink 10, corresponding to the first phase 41, the second phase 42, and the third phase 43, respectively being the output busbar first part 32a, output busbar second part 32b, and output busbar third part 32c.

Since each phase is divided into two parts located on the front and rear mounting surfaces of the heat sink 10, and each phase's input busbar 31 and output busbar 32 need to connect all the switch modules in that phase, the input busbar 31 can bypass the upper edge of the heat sink 10 to connect the switch modules on the front and rear sides of the heat sink 10. Similarly, the output busbar 32 can bypass the lower edge of the heat sink 10 to connect the switch modules on the front and rear sides of the heat sink 10.

Refer to Fig. 11b. The capacitor busbar 50 is located on the rear side of the heat sink 10, and the three single-phase switch tube groups 40 are installed on the front and rear mounting surfaces of their respective heat sinks 10. The extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Specifically, the input busbar first part 31a includes a positive plate, a neutral plate, and a negative plate. After the three are stacked, they are connected to the corresponding plates of the capacitor busbar 50. The input busbar 31 also includes a positive plate, a neutral plate, and a negative plate, which are stacked and connected to the corresponding plates of the capacitor busbar 50. Since the input ends of the three single-phase switch tube groups 40 are located at the upper edges of their respective heat sinks 10, three input busbars 31 are needed to connect to the capacitor busbar 50. However, since the three single-phase switch tube groups 40 are arranged side by side in the left-right direction, the distance from each single-phase switch tube group 40 to the capacitor busbar 50 is equal, ensuring the consistency of the current loop distance between each single-phase switch tube group 40 and the capacitor busbar 50. Regardless of the current direction of the capacitor busbar 50, the timing when it reaches each single-phase switch tube group 40 is also equal, resulting in the best current loop balance.

The output busbar first part 32a, output busbar second part 32b, and output busbar third part 32c are all located below the front mounting surfaces of the heat sinks 10, with their positions centrally distributed, facilitating external output wiring.

The power module provided in this embodiment, compared to Embodiments 1 to 4, improves the current loop balance between the capacitor busbar 50 and each single-phase switch tube group 40 by arranging the single-phase switch tube groups 40 side by side, ensuring the consistency of the current loop distance between the three single-phase switch tube groups 40 and the capacitor busbar 50, while also reducing stray inductance. Compared to Embodiment 7, by arranging the switch tubes 20 on both the front and rear sides of the heat sink 10, this embodiment further reduces the volume of the heat sink 10, improves the surface space utilization rate of the heat sink 10, and reduces the overall volume of the power module.

### Embodiment 9

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

As an optional embodiment, the three single-phase switch tube groups 40 are all installed on one heat sink 10. This eliminates the need for multiple heat sinks 10 as described in the background technology, effectively reducing the overall volume of the power module.

Furthermore, in the power module, each single-phase switch tube group is arranged side by side on the heat sink 10, and the layout direction of each single-phase switch tube group is parallel to the connection part; in each single-phase switch tube group, the layout direction of each switch module is consistent with the layout direction of each single-phase switch tube group. In each single-phase switch tube group 40, the layout direction of each switch module is parallel to the connection part of the capacitor busbar 50. This ensures that in each single-phase switch tube group 40, the distance from each switch module to the capacitor busbar 50 is equal, avoiding the problem of inconsistent commutation loop lengths of switch modules at different positions in each single-phase switch tube group 40.

Furthermore, the three single-phase switch tube groups 40 are divided into two parts to be respectively installed on the two mounting surfaces of the heat sink 10. On each mounting surface, the switch modules are arranged side by side in the left-right direction. In this embodiment, these two mounting surfaces are both parallel to the connection part. The mounting surface being parallel to the connection part can be seen as the flat heat sink 10 and the flat capacitor busbar 50 arranged in a stacked manner. This reduces the volume of the heat sink 10, further improves the space utilization rate of the heat sink 10, and reduces the overall volume of the power module.

The following provides further explanation of the above content.

In each single-phase switch tube group 40, the output tubes 22 of the switch modules are located on the front mounting surface of the heat sink 10, while the input tubes 21 of the switch modules are located on the rear mounting surface of the heat sink 10. Corresponding to this layout method, the "side by side arrangement" mentioned above means that in each single-phase switch tube group 40, the output tubes 22 are arranged side by side in the left-right direction, and the input tubes 21 are also arranged side by side in the left-right direction.

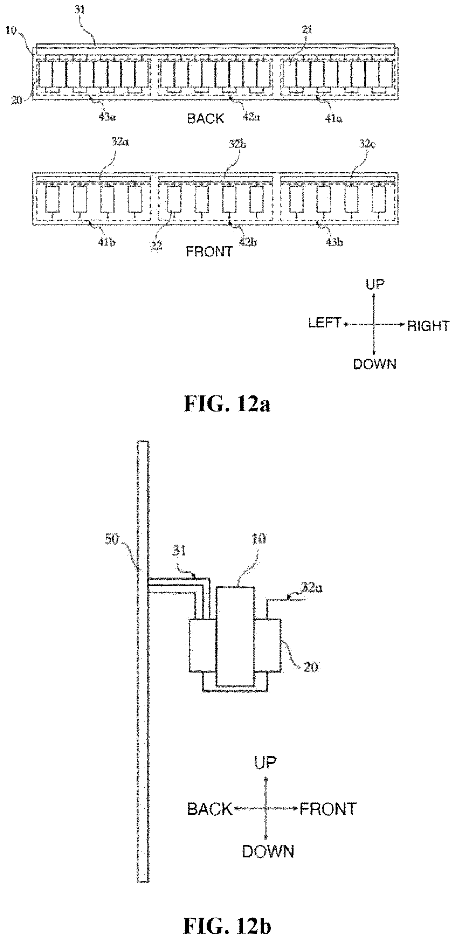

Refer to Fig. 12a, which shows the layout of the three single-phase switch tube groups 40 on the heat sink 10 in this embodiment, and indicates the corresponding directions. At the same time, refer to Fig. 12b, which shows the structure of this layout in a side view, and indicates the corresponding directions. It should be noted that the direction shown in Fig. 12a is when viewed from the front of the heat sink 10, facing the front mounting surface of the heat sink 10.

In this embodiment, each single-phase switch tube group 40 consists of four switch modules. The three single-phase switch tube groups 40 are respectively the first phase 41, the second phase 42, and the third phase 43. The first phase 41, the second phase 42, and the third phase 43 are each divided into two parts, respectively the first part 41a and the second part 41b of the first phase, the first part 42a and the second part 42b of the second phase, and the first part 43a and the second part 43b of the third phase. The first parts of each phase correspond to the input tubes 21 in the single-phase switch tube group 40, and the second parts correspond to the output tubes 22 in the single-phase switch tube group 40.

Refer to Fig. 12a. In each single-phase switch tube group 40, the input ends of the four switch modules together form the input end of the single-phase switch tube group 40, while the output ends of the four switch modules together form the output end of the single-phase switch tube group 40. In each phase, the first part is located on the rear mounting surface of the heat sink 10, and the second part is located on the front mounting surface of the heat sink 10. The first and second parts need to be connected through the connecting busbar 33, which can be arranged to bypass the lower edge of the heat sink 10.

Refer to Fig. 12a. Each single-phase switch tube group 40 is connected to the capacitor busbar 50 through the input busbar 31, and each is connected to an output busbar 32. The input and output ends of each phase of the three single-phase switch tube groups 40 are all located at the top. Therefore, an input busbar 31 can be arranged along the upper edge of the heat sink 10, connecting all three single-phase switch tube groups 40. At the same time, three output busbars 32 can be arranged along the upper edge of the heat sink 10, corresponding to the first phase 41, the second phase 42, and the third phase 43, respectively being the output busbar first part 32a, output busbar second part 32b, and output busbar third part 32c.

Refer to Fig. 12b. The capacitor busbar 50 is located on the rear side of the heat sink 10, and the three single-phase switch tube groups 40 are installed on the front and rear mounting surfaces of the heat sink 10. The extension direction of the input busbar 31 is parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses.

Specifically, the input busbar first part 31a includes a positive plate, a neutral plate, and a negative plate. After the three are stacked, they are connected to the corresponding plates of the capacitor busbar 50. The input busbar 31 also includes a positive plate, a neutral plate, and a negative plate, which are stacked and connected to the corresponding plates of the capacitor busbar 50. Since the input ends of the three single-phase switch tube groups 40 are located at the upper edge of the heat sink 10, only one input busbar 31 is needed to connect to the capacitor busbar 50. Therefore, the distance from each single-phase switch tube group 40 to the capacitor busbar 50 is equal, ensuring the consistency of the current loop distance between each single-phase switch tube group 40 and the capacitor busbar 50. Regardless of the current direction of the capacitor busbar 50, the timing when it reaches each single-phase switch tube group 40 is also equal, resulting in the best current loop balance.

The output busbar first part 32a, output busbar second part 32b, and output busbar third part 32c are all located above the front mounting surface of the heat sink 10, with their positions centrally distributed, facilitating external output wiring.

The power module provided in this embodiment, compared to Embodiments 1 to 4, improves the current loop balance between the capacitor busbar 50 and each single-phase switch tube group 40 by arranging the single-phase switch tube groups 40 side by side, ensuring the consistency of the current loop distance between the three single-phase switch tube groups 40 and the capacitor busbar 50, while also reducing stray inductance. Compared to Embodiment 7, by arranging the switch tubes 20 on both the front and rear sides of the heat sink 10, this embodiment further reduces the volume of the heat sink 10, improves the surface space utilization rate of the heat sink 10, and reduces the overall volume of the power module.

In addition, in Embodiment 3, since the three single-phase switch tube groups 40 are arranged in parallel in the vertical direction, one single-phase switch tube group 40 is necessarily located in the middle position. This causes the input busbar and output busbar corresponding to that single-phase switch tube group 40 to occupy the surface space of the mounting surface of the heat sink 10, resulting in lower surface space utilization of the heat sink 10, and the overall volume of the power module cannot be compressed to the limit. In this embodiment, the three single-phase switch tube groups 40 are arranged side by side in the left-right direction. Although this increases the length of the power module in the left-right direction, the input busbar and output busbar do not occupy the surface space of the mounting surface of the heat sink 10. Therefore, the surface space utilization rate of the heat sink 10 is higher, which can further reduce the overall volume of the heat sink 10.

Furthermore, in this embodiment, the number of heat sinks 10 is one. However, in other embodiments, the number of heat sinks 10 can be set to three, arranged in the left-right direction. Each heat sink 10 corresponds to a complete single-phase switch tube group 40. The wiring method of the single-phase switch tube group 40 can refer to the wiring method of each single-phase switch tube group 40 in this embodiment. When using three heat sinks 10, the connecting busbar 33 in each single-phase switch tube group 40 can directly bypass the upper or lower edge of the heat sink 10 in which it is located. Using three heat sinks 10 reduces the cooling capacity requirements of a single heat sink 10, which can lower the cost of the heat sink 10, and also facilitates the wiring and maintenance of each single-phase switch tube group on each heat sink 10.

### Embodiment 10

This embodiment provides a power module that mainly includes a heat sink 10, a capacitor module, and a power module.

Refer to Embodiment 1 for the introduction of the heat sink 10, capacitor module, and power module.

The layout of the switch tubes 20 in the power module mentioned above is described below.

As an optional embodiment, the surface of the heat sink 10 forms two mounting surfaces parallel to the connection part for installing each single-phase switch tube group. One mounting surface faces the connection part, while the other faces away from it. In each switch module, one input tube and one output tube are mounted on the same mounting surface, while the other input tube is mounted on the other mounting surface. This eliminates the need for multiple heat sinks 10 as described in the background technology, effectively reducing the overall volume of the power module. In this embodiment, these two mounting surfaces are both parallel to the connection part. The mounting surface being parallel to the connection part can be seen as the flat heat sink 10 and the flat capacitor busbar 50 arranged in a stacked manner.

Furthermore, in each single-phase switch tube group 40, the layout direction of each switch module is parallel to the connection part of the capacitor busbar 50. This ensures that in each single-phase switch tube group 40, the distance from each switch module to the capacitor busbar 50 is equal, avoiding the problem of inconsistent commutation loop lengths of switch modules at different positions in each single-phase switch tube group 40.

Additionally, in each single-phase switch tube group, the input tubes or output tubes located on the same mounting surface are arranged side by side in the left-right direction, and the two input tubes and output tube in each switch module are connected by a connecting busbar 33. The connecting busbar 33 passes through the heat sink 10 to connect the input tubes and output tubes located on their respective mounting surfaces.

Furthermore, each single-phase switch tube group is arranged side by side on the heat sink 10. In each switch module, the input tubes and output tubes mounted on the same mounting surface are arranged in the vertical direction, and the two input tubes correspond in position. In each switch module, the input ends of the two input tubes point in the same direction and are connected to the same input busbar. In each switch module, the input end of the input tube mounted on the same mounting surface as the output tube points away from the output end of the output tube.

The following provides further explanation of the above content.

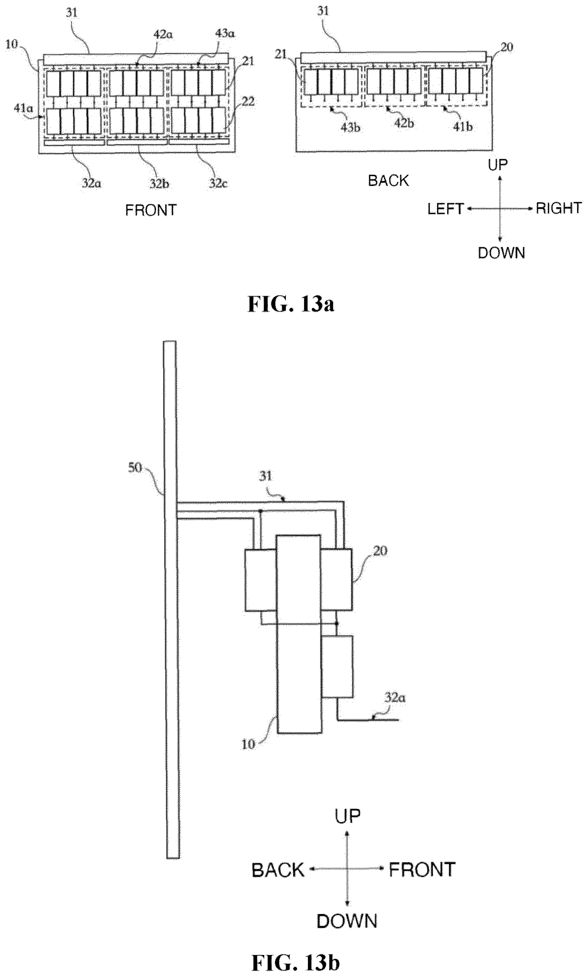

Specifically, refer to Fig. 13a, which shows the layout of the three single-phase switch tube groups 40 on the heat sink 10 in this embodiment, and indicates the corresponding directions. At the same time, refer to Fig. 13b, which shows the structure of this layout in a side view, and indicates the corresponding directions. It should be noted that the direction shown in Fig. 13a is when viewed from the front of the heat sink 10, facing the front mounting surface of the heat sink 10.

In this embodiment, each single-phase switch tube group 40 consists of four switch modules. The three single-phase switch tube groups 40 are respectively the first phase 41, the second phase 42, and the third phase 43. The first phase 41, the second phase 42, and the third phase 43 are each divided into two parts, respectively the first part 41a and the second part 41b of the first phase, the first part 42a and the second part 42b of the second phase, and the first part 43a and the second part 43b of the third phase. The first parts of each phase correspond to one input tube 21 and one output tube 22 in the single-phase switch tube group 40, while the second parts correspond to the other input tube 21 in the single-phase switch tube group 40.

Refer to Fig. 13a. In each single-phase switch tube group 40, the input ends of the two input tubes 21 in the four switch modules together form the input end of the single-phase switch tube group 40, while the output ends of the four switch modules together form the output end of the single-phase switch tube group 40.

The first phase 41, the second phase 42, and the third phase 43 are arranged side by side on the heat sink 10. The first part 41a of the first phase is located on the front mounting surface of the heat sink 10, while the second part 41b of the first phase is located on the rear mounting surface of the heat sink 10. The first part 42a of the second phase is located on the front mounting surface of the heat sink 10, while the second part 42b of the second phase is located on the rear mounting surface of the heat sink 10. The first part 43a of the third phase is located on the front mounting surface of the heat sink 10, while the second part 43b of the third phase is located on the rear mounting surface of the heat sink 10. This leaves an unoccupied mounting surface area on the lower part of the rear mounting surface of the heat sink 10, improving the cooling efficiency of the heat sink 10.

In the first part 41a of the first phase, the input tube 21 is located at the upper position of the front mounting surface of the heat sink 10, and the output tube 22 is located at the lower position of the front mounting surface of the heat sink 10, directly below its corresponding input tube 21. In the second part 41b of the first phase, the input tube 21 is located at the upper position of the rear mounting surface of the heat sink 10, corresponding in position to the input tube 21 in the first part 41a. The input tube 21 and output tube 22 in the first part 41a are connected by a connecting busbar 33, and the output tube 22 in the first part 41a and the input tube 21 in the second part 41b are also connected by a connecting busbar 33. Since the output tube 22 in the first part 41a and the input tube 21 in the second part 41b are located on different mounting surfaces of the heat sink 10, a hole can be made in the corresponding position of the heat sink 10 to allow the connecting busbar 33 to pass through and connect the output tube 22 in the first part 41a and the input tube 21 in the second part 41b.

Refer to Fig. 13a. Each single-phase switch tube group 40 is connected to the capacitor busbar 50 through the input busbar 31, and each is connected to an output busbar 32. The input and output ends of the first phase 41, the second phase 42, and the third phase 43 are all located at the top, corresponding to the upper edge of the heat sink 10, so one input busbar 31 is sufficient. Refer to Fig. 13b, since the two input tubes 21 in each phase are located on the front and rear mounting surfaces of the heat sink 10, respectively, the structure of the input busbar 31 in this embodiment is different from those in Embodiments 1 to 9.

Refer to Fig. 13b. The capacitor busbar 50 is located on the rear side of the heat sink 10, and the input busbar 31 extends parallel to the plate surface of the capacitor busbar 50. Thus, in each single-phase switch tube group 40, the distance from each switch module to the capacitor busbar 50 through the input busbar 31 is equal, so the commutation loop lengths of each switch module are equal, reducing stray inductance and consequently switching losses. For the input busbar 31, it includes a positive plate, a neutral plate, and a negative plate. Taking the first phase 41 as an example, in this embodiment, the input tube 21 in the first part 41a of the first phase is connected to the positive plate and neutral plate of the input busbar 31, while the input tube 21 in the second part 41b of the first phase is connected to the negative plate and neutral plate of the input busbar 31. In this case, the positive plate and neutral plate of the input busbar 31 need to bypass the front side of the heat sink 10 to connect to the input tube 21 in the first part 41a, and the positive plate and neutral plate of the input busbar 31 can be stacked. The input tube 21 in the second part 41b of the first phase can be directly connected to the negative plate and neutral plate of the capacitor busbar 50. The input tube 21 in the second part 41b of the first phase can be connected to the negative plate and neutral plate of the capacitor busbar 50 through terminal posts or wiring terminals. These terminal posts and wiring terminals still fall under the category of the input busbar 31, but these terminal posts or wiring terminals do not need to be stacked with the positive plate and neutral plate of the input busbar 31, thus reducing the manufacturing cost of the input busbar 31. Meanwhile, under this layout configuration, the commutation loop of the power module is shortened, and the overall stray inductance is lower. Even without stacking the three plates of the input busbar 31, it can still meet the usage requirements.

Similarly, the input busbar 31 of the second phase 42 and the third phase 43 also adopts the above wiring method. At the same time, the first phase 41, the second phase 42, and the third phase 43 share the same input busbar 31.

Since the input ends of the three single-phase switch tube groups 40 are located at the upper edge of the heat sink 10, only one input busbar 31 is needed to connect to the capacitor busbar 50. Therefore, the distance from each single-phase switch tube group 40 to the capacitor busbar 50 is equal, ensuring the consistency of the current loop distance between each single-phase switch tube group 40 and the capacitor busbar 50. Regardless of the current direction of the capacitor busbar 50, the timing when it reaches each single-phase switch tube group 40 is also equal, resulting in the best current loop balance.

The output busbar first part 32a, output busbar second part 32b, and output busbar third part 32c are all located below the front mounting surface of the heat sink 10, with their positions centrally distributed, facilitating external output wiring.

The power module provided in this embodiment, by arranging the two input tubes 21 in each switch module on the front and rear sides of the heat sink 10, shortens the overall commutation loop of the three-level topology, reducing the generation of stray inductance. By arranging the single-phase switch tube groups 40 side by side, the distance of the current loop between the capacitor busbar 50 and each single-phase switch tube group 40 is consistent, thus improving the current loop balance between the capacitor busbar 50 and each single-phase switch tube group 40.

Compared to Embodiment 9, the power module provided in this embodiment also has the following advantages:

In Embodiment 9, each switch module is arranged side by side in the left-right direction, resulting in an excessive length of the power module in the left-right direction. This not only causes certain difficulties in practical use but also affects the heat sink 10. Since the heat sink 10 uses a liquid-cooled heat sink, it requires coolant to be introduced internally. If coolant is introduced at the left or right end of the heat sink 10, the other end of the heat sink 10, due to being too far from the coolant inlet, will cause a decrease in the temperature uniformity of the heat sink 10 at different positions. If coolant is introduced at the upper or lower end of the heat sink 10, the coolant pipeline will interfere with the input busbar 31 or output busbar 32 of the power module.

In this embodiment, in each switch module, one input tube and one output tube are arranged in the vertical direction on the mounting surface, and then the switch modules are arranged side by side in the left-right direction. This shortens the length of the power module in the left-right direction and increases the length of the power module in the vertical direction. This makes the dimensions of the power module more balanced in the left-right and vertical directions. Besides being easier to use in practice, the heat sink 10 can also choose to introduce coolant at the left or right end. Due to the shortened length in the left-right direction, the coolant can achieve better performance at all positions of the heat sink 10, resulting in better overall temperature uniformity of the heat sink 10.

Moreover, when the number of switch tubes 20 in each switch module is three, in this embodiment, an empty part is left at the lower position on the rear mounting surface. In practical design of the coolant flow path, the upper half of the heat sink 10 can be designed as the coolant inlet flow path, while the lower half can be designed as the coolant return flow path. The coolant in the inlet flow path has a lower temperature, which can improve the cooling efficiency of the input tubes 21 that release higher temperatures. The higher temperature of the coolant in the return flow path will not affect the cooling efficiency of the output tubes 22 that release lower temperatures.

### Embodiment 11

This embodiment is a further refinement of Embodiment 10. In this embodiment, the layout of each single-phase switch tube group 40 is the same as in Embodiment 10. The only difference is that in this embodiment, each single-phase switch tube group 40 consists of three switch modules.

The following provides further explanation of the power module provided in this embodiment.

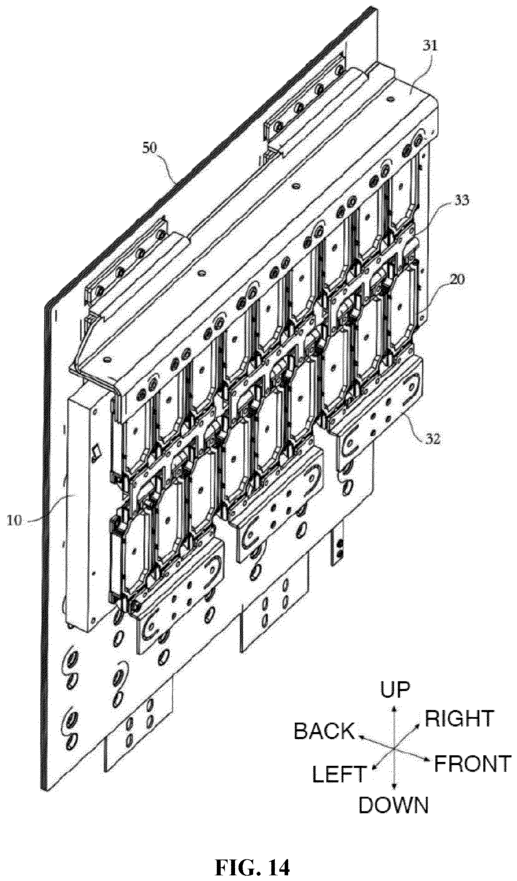

Refer to Fig. 14, which shows the structure of the heat sink 10, switch tubes 20, input busbar 31, output busbar 32, capacitor busbar 50, and connecting busbar 33 in the power module provided in this embodiment.

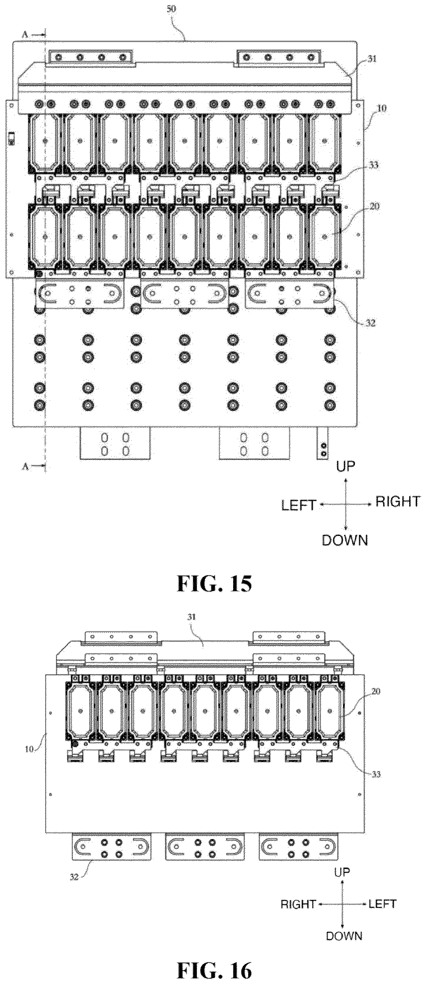

Refer to Figs. 15 and 16. In the power module provided in this embodiment, a single-phase switch tube group 40 consists of three switch modules, with a total of nine switch modules forming three single-phase switch tube groups 40. Each single-phase switch tube group 40 outputs single-phase AC through the corresponding output busbar 32, and the three groups together output three-phase AC. In each single-phase switch tube group 40, the two input tubes 21 are located on the front and rear mounting surfaces of the heat sink 10, respectively, at the upper position of the heat sink 10, and the output tube 22 is located on the front mounting surface of the heat sink 10 at the lower position. The input tube 21 and output tube 22 on the front mounting surface of the heat sink 10 are connected by a connecting busbar 33, and the input tube 21 on the rear mounting surface and the output tube 22 on the front mounting surface are connected by another connecting busbar 33, which passes through an opening in the heat sink 10 to connect the front and rear sides.

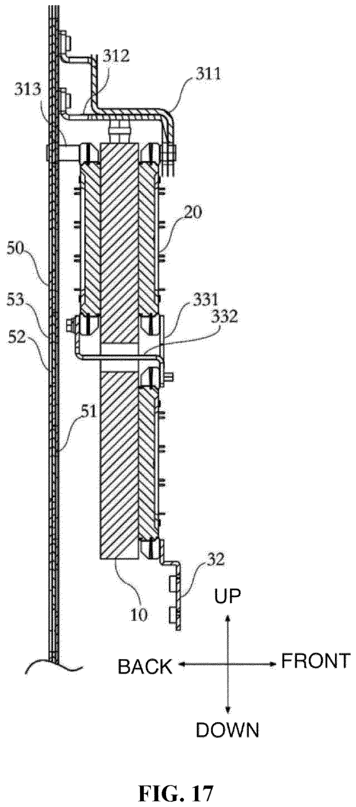

Refer to Fig. 17. In the power module provided in this embodiment, the capacitor busbar 50 includes three plates: the positive capacitor busbar plate 51, the neutral capacitor busbar plate 52, and the negative capacitor busbar plate 53. According to the direction shown in Fig. 17, the three plates are arranged from back to front as the positive capacitor busbar plate 51, the neutral capacitor busbar plate 52, and the negative capacitor busbar plate 53, stacked together, with the negative capacitor busbar plate 53 closest to the heat sink 10.

The input busbar 31 also includes three parts: the positive input busbar plate 311, the neutral input busbar plate 312, and the input terminal post 313. In this embodiment, the terminals of the input tubes 21 on the front mounting surface of the heat sink 10 are suitable for connection with the positive capacitor busbar plate 51 and the neutral capacitor busbar plate 52. Therefore, one end of the positive input busbar plate 311 and the neutral input busbar plate 312 is connected to the positive capacitor busbar plate 51 and the neutral capacitor busbar plate 52, respectively, while the other end extends to the front of the heat sink 10 to connect to the input tubes 21 in each switch module. Meanwhile, the terminals of the input tubes 21 on the rear mounting surface of the heat sink 10 are suitable for connection with the neutral capacitor busbar plate 52 and the negative capacitor busbar plate 53, and since there is no heat sink 10 blocking the connection between the capacitor busbar 50 and the input tubes 21, the input terminal post 313 can be directly used to connect the negative terminal of the input tubes 21 to the negative capacitor busbar plate 53, and the neutral terminal of the input tubes 21 to the neutral capacitor busbar plate 52.

The connecting busbar 33 includes two parts: the first part 331 and the second part 332. The first part 331 connects the input tubes 21 and output tubes 22 on the front mounting surface of the heat sink 10, while the second part 332 connects the input tubes 21 on the rear mounting surface to the output tubes 22 on the front mounting surface of the heat sink 10.

In this embodiment, the heat sink 10 used is a liquid-cooled heat sink, which can effectively meet the cooling needs of the switch tubes 20.

Compared to Embodiments 1-9, the power module provided in this embodiment not only reduces the overall volume of the heat sink 10 but also keeps the length and width of the heat sink 10 within an appropriate range, facilitating the practical application of the power module. The positions of the input and output terminals of each switch tube 20 are reasonably arranged, effectively reducing stray inductance and achieving good current loop balance.

### Embodiment 12

Embodiment 12 is based on Embodiment 10. The difference between the two is that in Embodiment 12:

In each switch module, the input tubes and output tubes mounted on the same mounting surface are arranged vertically, and the two input tubes are staggered in position. In each switch module, the input ends of the two input tubes face away from each other. In each switch module, the input end of the input tube and the output end of the output tube mounted on the same mounting surface also face away from each other.

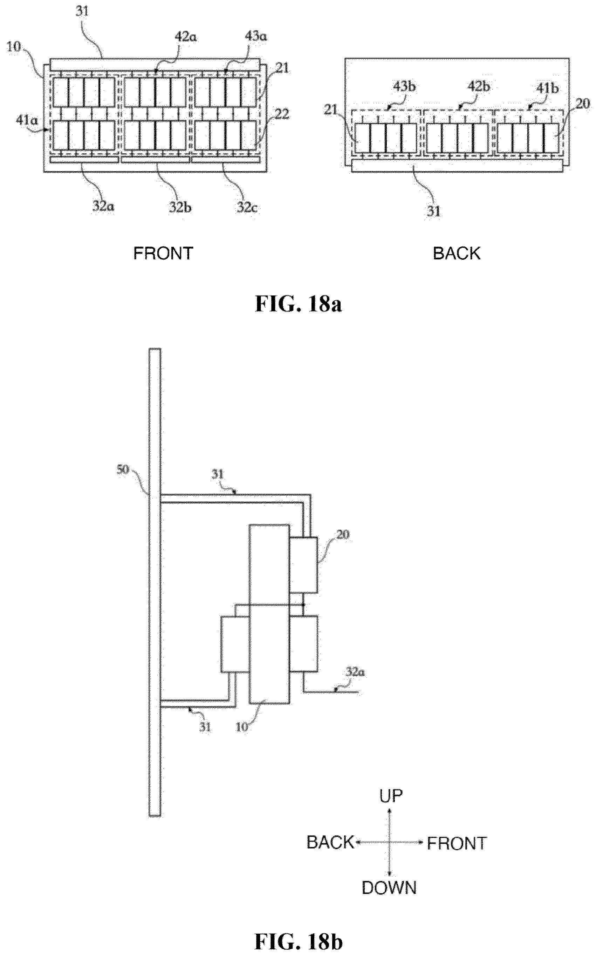

Refer to Figs. 18a and 18b. One input tube 21 is mounted at the upper part of the front mounting surface of the heat sink 10, with its input end located at the top. The other input tube 21 is mounted at the lower part of the rear mounting surface of the heat sink 10, with its input end located at the bottom. The connection between the input tube 21 on the front mounting surface and the input busbar 31 can refer to Embodiment 10. The input tube 21 on the rear mounting surface can be directly connected to the connection part of the capacitor busbar 50 through terminal posts, specifically referring to Embodiment 11.

### Embodiment 13

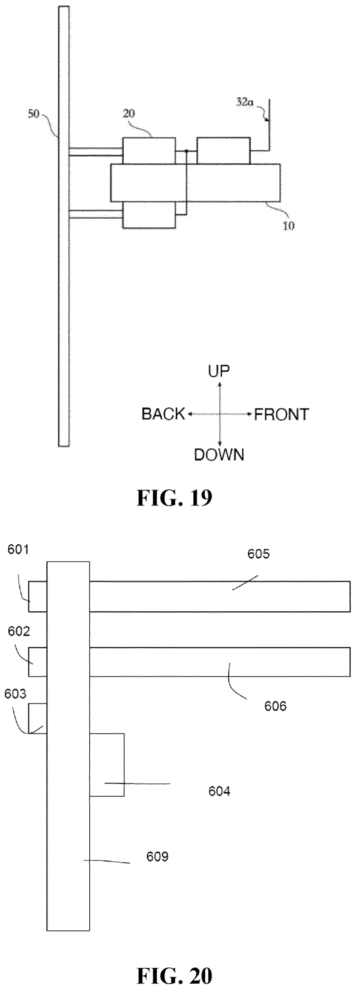

Refer to Fig. 19. This embodiment is based on Embodiment 10. The difference between the two is that in Embodiment 13, the mounting surface formed by the heat sink 10 has a certain inclination angle relative to the connection part, and one of the two formed mounting surfaces faces upward relative to the capacitor busbar 50, while the other faces downward.

Specifically, the mounting surface formed by the heat sink 10 is perpendicular to the connection part of the capacitor busbar 50, with one mounting surface facing upward and the other facing downward. Compared to Embodiment 10, referring to the content described in Embodiment 11, the input tubes 21 can be directly connected to the capacitor busbar through terminal posts without using busbars or the like, making the wiring more concise. In the same switch module, the two input tubes 21 are equidistant from the capacitor busbar 50, and this distance is shorter than that in Embodiment 10 under the same conditions, which can better reduce stray inductance.

It should be understood that this layout is also applicable to the above-mentioned Embodiments 1-9, with adaptive improvements as needed. However, to enhance the practical application effect of this layout, it is preferable to use the technical scheme where the input busbar 31 is located at the edge of the heat sink 10 and the three single-phase switch tube groups 40 are connected to the same input busbar 31 as the basis for improvement. Since the input busbar 31 is located at the edge, it can be directly connected to the capacitor busbar 50, reducing the length of the commutation loop and thereby reducing stray inductance.

### Embodiment 14

This embodiment provides a converter that includes a converter housing in which any of the power modules from Embodiments 1 to 13 is installed.

The heat sink 10 of the liquid-cooled converter uses a liquid-cooled heat sink.

In some embodiments, a power assembly apparatus includes a capacitor module, a power module, and at least one heat sink. The capacitor module includes interconnected direct current (DC) capacitor banks and a capacitor bus, wherein the capacitor bus has a connection part. The power module includes an input bus, an output bus, and three single-phase switching tube groups, wherein each single-phase switching tube group includes a plurality of switching modules. Each switching module is coupled to input tubes and output tubes, wherein the input bus is connected to the connection part, and the output bus is configured to output electrical energy. The heat sink has a mounting surface for mounting each of the single-phase switching tube groups to efficiently move away heat generated by the single-phase switching tube groups.

In some embodiments, each switching module is divided into a first part that includes only input tubes and a second part that includes only output tubes, wherein any mounting surface of the same heat sink includes only one part from the first part and the second part of the switching module. The heat sink has a mounting surface for mounting each single-phase switching tube group, wherein the mounting surface is parallel to the connection part. The heat sink has two mounting surfaces that are opposite to each other, wherein the two mounting surfaces are used for mounting each single-phase switching tube group, and each switching module is divided into a part that includes input tubes and output tubes and a part that includes only input tubes, wherein any mounting surface of the same heat sink includes only one part of each switching module.

In some embodiments, all single-phase switching tube groups in the power module are mounted on the heat sink, wherein the arrangement direction of each single-phase switching tube group is parallel to the connection part of the capacitor bus. The arrangement direction of each switching module in each single-phase switching tube group is consistent with the arrangement direction of the corresponding single-phase switching tube group. Each single-phase switching tube group in the power module is arranged in parallel on a heat sink, wherein the arrangement direction of each single-phase switching tube group is parallel to the connection part of the capacitor bus, and the arrangement direction of each switching module in each single-phase switching tube group is consistent with the arrangement direction of the corresponding single-phase switching tube group.

In some embodiments, each switching tube in the modules is divided based on type into input tubes and output tubes, wherein the input tubes and output tubes are arranged on different surfaces of at least one heat sink. The heat sink surfaces face towards a capacitor bus connection part, wherein the heat sink has two mounting surfaces, and the mounting surfaces are parallel and face away from each other. The heat sink surfaces face away from a capacitor bus connection part, wherein the heat sink has two mounting surfaces, and the mounting surfaces are parallel and face away from each other. Each single-phase switching tube group is split into parts, wherein the parts are mounted on different surfaces of the heat sink. The different surfaces of the heat sink are parallel, wherein the different surfaces face away from each other.

In some embodiments, the input tubes and output tubes in the same switching module are connected via connecting strips, wherein the connecting strips pass around the heat sink, and the connecting strips pass through the heat sink. The input bus and the output bus are arranged relative to the heat sink and switching modules, wherein the arrangement optimizes heat dissipation and electrical performance. Each switching module within the single-phase switching tube groups is further divided, wherein each divided part is positioned on the heat sink to enhance cooling efficiency. The single-phase switching tube groups comprise insulated gate bipolar transistors (IGBTs), wherein the single-phase switching tube groups are configured to handle high voltage and high current applications, and the single-phase switching tube groups have integrated gate drivers for efficient switching and control. The single-phase switching tube groups are optimized for thermal management to dissipate heat effectively through the heat sink, wherein the single-phase switching tube groups include protection features such as over-current and over-temperature protection to ensure reliable operation.

In some embodiments, a temperature sensor is placed on a surface of the heat sink, wherein the temperature sensor is configured to transmit collected ambient temperature data on the heat sink to a controller. The controller is configured to control the operation of the power module based on the transmitted temperature data, wherein the controller adjusts the power module's operation to optimize thermal performance and ensure safe operating conditions. Multiple temperature sensors are placed at different positions on the heat sink, wherein the multiple temperature sensors are configured to transmit collected ambient temperature data to a controller. The controller analyzes the multiple temperature data to determine an optimized way to control the power module, wherein the controller adjusts the power module's operation based on the analysis to optimize thermal performance and ensure safe operating conditions. The controller further adjusts the power module's operation to prevent overheating and maximize efficiency based on the real-time temperature data received from the multiple temperature sensors.

In some embodiments, the DC capacitor banks are placed at a first side of a bracket for disposing the capacitor bus, wherein the three single-phase switching tube groups are placed at a second side of the bracket. The three single-phase switching tube groups are placed on multiple sub-brackets protruding from the bracket for disposing the capacitor bus.

Fig. 20 illustrates an embodiment of a power assembly apparatus. Multiple temperature sensors 601, 602, 603 are placed at different positions on the heat sink 609. The multiple temperature sensors 601, 602, 603 are configured to transmit collected ambient temperature data to a controller 604. The controller 604 analyzes the multiple temperature data to determine an optimized way to control the power module 605, 606. The controller 604 adjusts the power module's operation based on the analysis to optimize thermal performance and ensure safe operating conditions. The controller further adjusts the power module's operation to prevent overheating and maximize efficiency based on the real-time temperature data received from the multiple temperature sensors.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings.

The embodiments were chosen and described in order to best explain the principles of the techniques and their practical applications. Others skilled in the art are thereby enabled to best utilize the techniques and various embodiments with various modifications as are suited to the particular use contemplated.

Although the disclosure and examples have been fully described with reference to the accompanying drawings, it is to be noted that various changes and modifications will become apparent to those skilled in the art. Such changes and modifications are to be understood as being included within the scope of the disclosure and examples as defined by the claims.

## Claims

1. A power assembly apparatus, comprising:
a capacitor module, wherein the capacitor comprises interconnected direct current (DC) capacitor banks (02) and a capacitor bus (01), wherein the capacitor bus (01) has a connection part;
a power module, wherein the power module has an input bus (03), an output bus (05), and three single-phase switching tube groups (04), wherein each single-phase switching tube group (04) comprises a plurality of switching modules (04), wherein each switching module (04) is divided into input tubes (04a) and output tubes (04b), wherein the input bus (03) is connected to the connection part, wherein the output bus (05) is configured to output electrical energy; and
at least one heat sink (06), wherein each switching module is distributed across different mounting surfaces of the heat sink (06) for efficiently move away heat generated by the single-phase switching tube groups (04).

2. The power assembly apparatus of claim 1, wherein the heat sink (06) has a mounting surface for mounting each single-phase switching tube group (04), wherein the mounting surface is parallel to the connection part, wherein the heat sink (06) has two mounting surfaces that are opposite to each other, wherein the two mounting surfaces are used for mounting each single-phase switching tube group (04).

3. The power assembly apparatus of any one of claims 1-2, wherein the heat sink (06) has a mounting surface for mounting each single-phase switching tube group (04), wherein the mounting surface is parallel to the connection part.

4. The power assembly apparatus of any one of claims 1-3, wherein the heat sink (06) has two mounting surfaces that are opposite to each other, wherein the two mounting surfaces are used for mounting each single-phase switching tube group (04), wherein each switching module (04) is divided into a first part including only input tubes (04a) and a second part including only output tubes (04b), wherein any mounting surface of the same heat sink (04) includes only one part from the first part and the second part of the switching module; or
wherein each switching module is divided into a part including input tubes (04a) and output tubes (04b), and a part including only input tubes, wherein any mounting surface of the same heat sink (04) includes only one part of each switching module.

5. The power assembly apparatus of any one of claims 1-4, wherein all single-phase switching tube groups (04) in the power module are mounted on the heat sink (06), wherein the arrangement direction of each single-phase switching tube group (04) is parallel to the connection part of the capacitor bus (01), wherein the arrangement direction of each switching module (04) in each single-phase switching tube group (04) is consistent with the arrangement direction of the corresponding single-phase switching tube group (04).

6. The power assembly apparatus of any one of claims 1-4, wherein each single-phase switching tube group (04) in the power module is arranged in parallel on a heat sink (06), wherein the arrangement direction of each single-phase switching tube group (04) is parallel to the connection part of the capacitor bus (01), wherein the arrangement direction of each switching module (04) in each single-phase switching tube group (04) is consistent with the arrangement direction of the corresponding single-phase switching tube group (04).

7. The power assembly apparatus of any one of claims 1-3, wherein each switching tube (04) in the modules is divided based on type into input tubes (04a) and output tubes (04b), wherein the input tubes (04a) and output tubes (04b) are arranged on different surfaces of at least one heat sink (06).

8. The power assembly apparatus of any one of claims 1-7, wherein the heat sink surfaces face towards a capacitor bus connection part, wherein the heat sink (06) has two mounting surfaces, wherein the mounting surfaces are parallel and face away from each other, or
wherein the heat sink surfaces face away from a capacitor bus connection part, wherein the heat sink (06) has two mounting surfaces, wherein the mounting surfaces are parallel and face away from each other.

9. The power assembly apparatus of any one of claims 1-8, wherein each single-phase switching tube group (04) is split into parts, wherein the parts are mounted on different surfaces of the heat sink (06).

10. The power assembly apparatus of any one of claims 1-9, wherein the different surfaces of the heat sink (06) are parallel, wherein the different surfaces face away from each other.

11. The power assembly apparatus of any one of claims 1-10, wherein the input tubes (04a) and output tubes (04b) in the same switching module are connected via connecting strips, wherein the connecting strips pass around the heat sink (06),
wherein the connecting strips pass through the heat sink (06).

12. The power assembly apparatus of any one of claims 1-11, wherein the input bus and the output bus are arranged relative to the heat sink and switching modules, wherein the arrangement optimizes heat dissipation and electrical performance, and/or
each switching module within the single-phase switching tube groups (04) is further divided, wherein each divided part is positioned on the heat sink to enhance cooling efficiency.

13. The power assembly apparatus of any one of claims 1-12, wherein the single-phase switching tube groups (04) comprise insulated gate bipolar transistors (IGBTs), wherein the single-phase switching tube groups (04) are configured to handle high voltage and high current applications, wherein the single-phase switching tube groups (04) have integrated gate drivers for efficient switching and control, wherein the single-phase switching tube groups (04) are optimized for thermal management to dissipate heat effectively through the heat sink, and wherein the single-phase switching tube groups (04) include protection features such as over-current and over-temperature protection to ensure reliable operation, and/or
wherein a temperature sensor is placed on a surface of the heat sink (06), wherein the temperature sensor is configured to transmit collected ambient temperature data on the heat sink (06) to a controller (604), wherein the controller (604) is configured to control the operation of the power module based on the transmitted temperature data, wherein the controller (604) adjusts the power module's operation to optimize thermal performance and ensure safe operating conditions, wherein multiple temperature sensors (601, 602, 603) are placed at different positions on the heat sink, wherein the multiple temperature sensors (601, 602, 603) are configured to transmit collected ambient temperature data to a controller (604), wherein the controller analyzes the multiple temperature data to determine an optimized way to control the power module, wherein the controller (604) adjusts the power module's operation based on the analysis to optimize thermal performance and ensure safe operating conditions, wherein the controller (604) further adjusts the power module's operation to prevent overheating and maximize efficiency based on the real-time temperature data received from the multiple temperature sensors (601, 602, 603).

14. The power assembly apparatus of any one of claims 1-13, wherein the DC capacitor banks (02) are placed at a first side of a bracket for disposing the capacitor bus (01), wherein the three single-phase switching tube groups (04) are placed at a second side of the bracket,
and/or wherein the three single-phase switching tube groups are placed on multiple sub-brackets protruding from the bracket for disposing the capacitor bus.

15. A liquid cooling converter comprising the power assembly apparatus of any one of claims 1-14.
